# EUROPEAN PATENT APPLICATION

(11) **EP 4 566 819 A1**
(43) Date of publication of application: **11.06.2025**
(21) Application number: 24217093.4
(22) Date of filing: 03.12.2024
(51) Int. Cl.: B33Y 10/00, B33Y 30/00, B33Y 70/00, G03F 7/00, G03F 7/029, G03F 7/031, G03F 7/095, G03F 7/20

(54) **NAPHTHOPYRAN PHOTOSWITCHABLE PHOTOINITIATORS FOR LOCALLY POLYMERIZING A STARTING MATERIAL BY DUAL COLOR PHOTOPOLYMERIZATION**

(30) Priority: 05.12.2023 DE 102023133926
(71) Applicant: Xolo GmbH, 12489 Berlin (DE)
(72) Inventor: GARMSHAUSEN, Yves, 12621 Berlin (DE)
(74) Representative: Erbacher, Martin

(57) **Abstract**

The present invention relates to a process for locally polymerizing a starting material by dual color photopolymerization using photoinitiator molecule which is represented by one of the following formula (Ib)

## Description

### Field of invention

The present invention relates to naphthopyran photoswitchable photoinitators for locally polymerizing a starting material by dual color photopolymerization and a method for volumetric printing of a shaped body (xolography). In particular, photoinitiators based on [2,1-b]naphthopyran are provided, which cause efficient curing of photopolymerizable formulations upon irradiation with two different wavelengths and which may be used for volumetric printing (xolocure initiators).

### Background of Art

A definition of photoswitches, structures which are photochromic, and terms used in the field can be found in [Bouas-Laurent, Dürr, Pure and Applied Chemistry, 2001, 73, 639-665]. In general, a photoswitch is a photochromic compound which can undergo a reversible structural change in at least one direction via a photochemical path. A typical example is the [1,2-b]naphthopyran/merocyanine system (top) and the [2,1-b]naphthopyranjmerocyanine system (bottom), as illustrated in below:

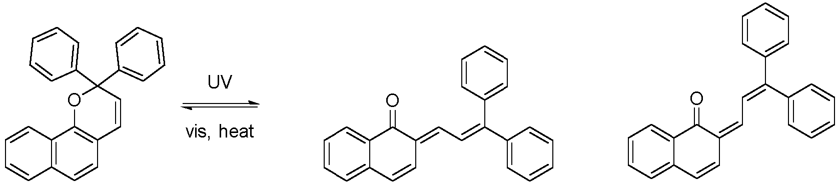

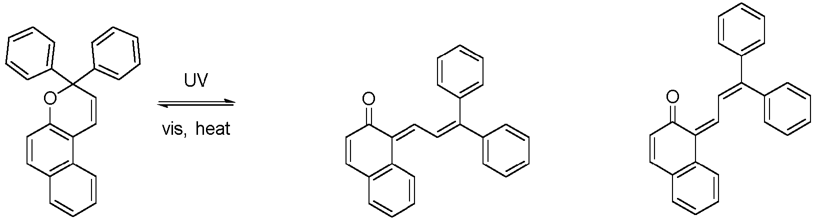

The typically colorless naphthopyran is the thermodynamically favored form and undergoes a ring opening reaction upon irradiation with UV light to the metastable colored merocyanine form (positive photochromism). The merocyanine form can be a mixture of different isomers. Within this patent the term merocyanine refers to one or more of the different E/Z isomers. The reverse reaction from merocyanine to naphthopyran can be conducted either by light or thermally (T type photochromism). The naphthopyran photoswitches belong to the group of chromene based switches, which are usually positive and T-type photochromic.

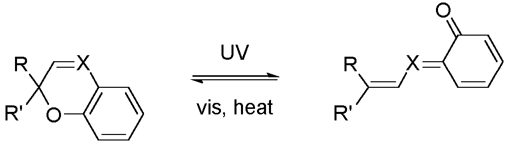

In such chromene based photoswitches, R and R' can be alkyl, alkyne, or aryl substituents, and X can be a carbon or a nitrogen atom. Various derivatives of this family are photochromic, wherein the aryl part is further substituted, or the oxygen atom is changed for a nitrogen atom. The double bonds of the open form can be E and/or Z configured.

An overview on photoinitiators with terms and definitions can be found in [Green, Industrial Photoinitiators A Technical Guide, CRC Press, 2010; Fouassier and Lalevee, Photoinitiators for Polymer Synthesis: Scope, Reactivity and Efficiency, Wiley VCH, 2012]. Curing of a material refers to the polymerization of monomers. Depending on the mechanism of the polymerization several functional groups have been found to be suitable monomers, which include but are not limited to acrylates, methacrylates, thiol + ene, epoxides, oxiranes, oxetanes, or vinylethers. Photoinitiators start the polymerization upon irradiation with light. The polymerization can be conducted in a radical fashion, cationic, anionic, or metal catalyzed. Photoinitiators are either type 1, where a single compound can start the polymerization or type 2, where a co initiator is required. Type 1 photoinitiators can undergo homolytic (radical) or heterolytic bond cleavage (cationic/anionic) to form the reactive species. In the following reactions further species can be produced which can cause a different nature of the polymerization, e.g. an amine radical is initially produced by homolytic bond cleavage, which than abstracts a hydrogen atom from the environment to form an amine and start a base mediated polymerization. Type 2 photoinitiators can start the polymerization by two different mechanisms, where the first is hydrogen abstraction from a co initiator, which produces two radicals and can cause further reactive species from follow up reactions. The second mechanism is a photoredox reaction, where an electron is transferred between co initiator and photoinitiator. The photoredox reaction can be proceeded by further proton transfer reactions to produce radicals or other follow up reactions which result in further reactive species such as acids, bases or radicals. Several structural motives are known to initiate a polymerization and examples of the most important ones are shown below.

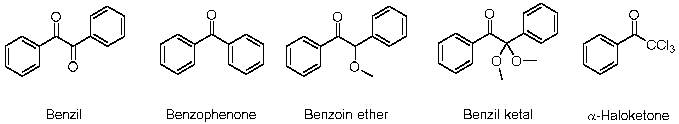

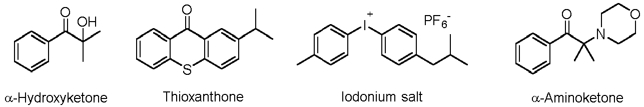

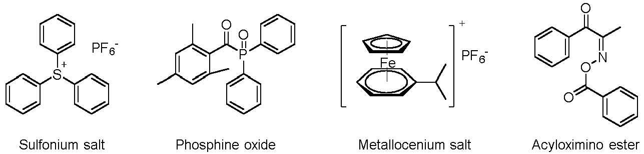

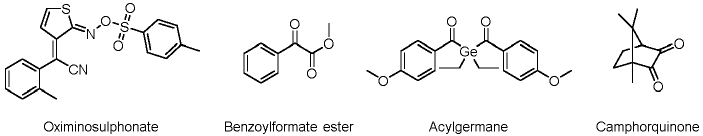

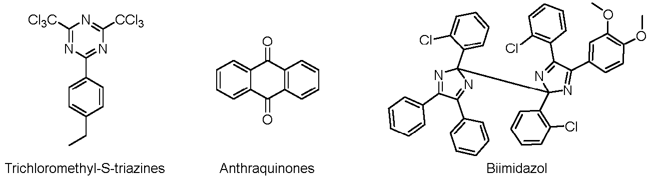

Additive manufacturing or 3D printing can be performed with various techniques and materials and allows to produce customized parts. Compared to injection molding, additive manufacturing enables the formation of more complex structures, saving material and giving the opportunity to construct specialized parts for machines with superior performance. However, most of the additive manufacturing techniques rely on a layer by layer build sequence. Therefore, the object is sliced into many layers and one layer is printed after the other. Consequently, certain limitations are inherent, which is the necessity for support structures to prevent overhanging parts from falling apart. Usually, several mechanical steps are involved between printing of the layers, which leads to long production times. The starting material for a print must be in a form to allow for the mechanical operations without destruction of the object, which restricts starting materials to certain powder sizes or viscosities.

One of the most prominent 3D printing techniques is stereolithography [Hull, US4575330, 1984] and techniques related to stereolithography. In general, a thin layer of a photocurable resin is irradiated with a specific pattern of light of one wavelength. This causes a photopolymerization and results in hardening at the illuminated areas. Then a new layer of photocurable resin is introduced from the top or bottom of the previous layer, and illumination leads to curing in this layer. The advantage of irradiation-based techniques is the fast process of photopolymerization and the high resolution in which light can be applied to a layer as well as a certain flexibility in terms of material properties. Although stereolithography is a well-known technique, the previously mentioned drawbacks still apply. Stereolithography requires support structures, which makes an elaborate post-processing necessary. Despite the fast photopolymerization, the slow mechanical processes to go from one layer to the next reduce the overall production speed of stereolithography. Furthermore, the resin must fulfill certain criteria, such as low viscosity to enable flow and homogeneity of the layers as well as a high absorption at the irradiation wavelength to avoid curing in the previous layers. The requirement of thin layers for a high resolution as well as the low viscosity result in high oxygen and water concentrations at the surface. While water quenches the cationic polymerization process, oxygen quenches the radical process. Although the latter can be improved by the addition of amines, the resins require high concentrations of costly photoinitiators to overcome the inhibition process but still yield less crosslinked materials which are therefore less robust.

To overcome the limitations of stereolithography, volumetric printing has been proposed as a solution. In such an approach the resin is in a container and by the action of light curing does not happen on the walls of the container but inside the volume. This removes the necessity of support structures, allows for resins of low and high viscosity, allows the formation of soft objects, and does not suffer from the inhibition by oxygen or water.

One implementation of volumetric printing relies on two photon polymerization, where a common photoinitiator is excited by the simultaneous uptake of two photons, causing polymerization in the focus of a laser beam [S. Maruo et al., Opt. Lett., 1997, 22, 132-134]. Two photon polymerization requires costly and delicate setups with intense pulsed laser sources. Furthermore, the technique is inherently slow due to the nonlinearity of the process, reducing the achievable object size considerably.

Furthermore, the method of tomographic reconstruction has been developed, where the resin is illuminated with different light patterns from various angles. Due to the overlaying light an intensity distribution in the volume is generated, which causes curing wherever a certain threshold is exceeded. The light patterns which are required to form a three-dimensional object are calculated before in a similar way to a reverse process of computer tomographic analysis [Kelly et al., US20180326666A1, 2018; Shusteff et al., US20180015672A1, 2018; Delrot et al. WO2019043529A1, 2019]. This technique suffers from the inherent disadvantage to match the hardening threshold at every position in the volume. Furthermore, the resin rotates, causing diffusion while curing. Both effects cause a low resolution and object size. Furthermore, this technique does not allow to produce objects with sharp edges and is therefore limited to round surfaces of the printed parts.

To overcome the issues of two photon polymerization and tomographic reconstruction, a dual color photoinitiating system has been disclosed in WO2020245456. This requires a photoinitiator which upon irradiation with light of a first wavelength λ1 is transformed from its thermodynamically stable ground state form A into a metastable ground state species B. When species B absorbs light of the second wavelength λ2, it can initiate a polymerization reaction via form C. Form C is an excited state of B, which produces radicals, cations or anions by further reaction with or without a co-initiator. In the sense of this invention the terms first wavelength, second wavelength, and third wavelength can refer to a range of wavelengths. For usage in a volumetric printing approach a back reaction from B to A must be possible to avoid hardening of unwanted areas. The back reaction from B to A can be triggered thermally or by irradiation with a third wavelength λ3.

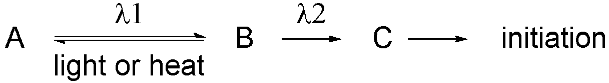

There are two unwanted reaction pathways, which could lead to polymerization with the first wavelength alone. A can directly initiate the polymerization instead of switching or B can absorb a photon of the first wavelength and initiate the polymerization. Ideal dual color photoinitiators which are suitable for volumetric printing do not suffer from these unwanted reactions and are thermally reversible or can be switched back by irradiation with a third wavelength. The following examples are related to photoinitiators and multiple wavelengths irradiation, although all of them suffer from unwanted side reactions and/or a lack of thermal reversibility. So far, no three-dimensional objects other than single voxels have been made, which does not require any thermal or photochemical back reaction and is not sufficient for volumetric printing.

A related concept has been first proposed by Swainson in a series of patents [Swainson, US4041476, US4078229, US4238840, US4466080, US4471470, US43331651 and later by Lippert (US2020/0108557A1). Several theoretical approaches are shown, where the photoinitiator is supposed to react to two or three different wavelengths. However, although the concept is interesting, none of the described molecules in the patents have been shown to respond to two different wavelengths initiating a polymerization and they are neither feasible nor commercially satisfactory for volumetric printing.

JP H0375127A by Kenji and Ichiro claimed three photoswitches for volumetric printing. The molecules described therein are known for their photochromic properties, but do not show selective curing, where beams of both wavelengths would intersect as has been shown by Neckers [US005230986A, column 6, line 27-35]. Even if they were able to initiate with dual color irradiation, they show a slow thermal reverse reaction from B to A, which makes them unsuitable in volumetric printing applications.

Barachevsky et al. [US7244548B2, 2007] and Waldman et al. [US2009/0202919A1] disclosed several initiators for recording phase holograms. In this type of application, a curable composition is irradiated with one wavelength first to induce the isomerization from A to B. Later, the second wavelength can be used to record a phase hologram by initiating the polymerization. This application requires photoinitiators which respond to two different wavelengths but do not show a thermal back reaction from B to A. The lack of a thermal back reaction renders the disclosed initiators not suitable for a volumetric printing approach.

US005230986A by Neckers disclosed iodinated benzospiropyrans with suitable co-initiators as two photon radical photoinitiators with the following structure, where at least one of the two substituents X1 and X3 is an iodine:

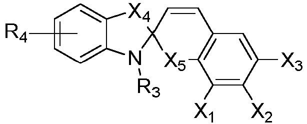

The disclosed molecules are of limited efficiency for photopolymerization, which makes high concentrations necessary [Lee, Neckers, Chem. Mater. 1991, 3, 852-858 and Lee, Neckers, Chem. Mater. 1991, 3, 858-864]. Consequently, the penetration depth of the light is limited and the volume suitable for printing cannot exceed 2 mm as has been shown by the same authors [Lee, Neckers, Chem. Mater. 1991, 3, 858-864, Figures 12 and 13]. The iodo substituent acts as a triplet sensitizer on the spiropyrane form, so that the unwanted side reaction from irradiation using the first wavelength alone is dominant, where the spiropyrane causes the photo redox reaction and hence formation of radicals, without isomerizing to the merocyanine.

Two other spiropyran-based two component systems have been reported for recording holograms [Jeudy, Robillard, Opt. Commun. 1975, 13, 25-28; Ichimura, Sakuragi, J. Polym. Sci. Polym. Lett, 1988, 26 185-189]. However, both are not suited for volumetric printing, since both cause substantial polymerization with the first wavelength alone [Lee, Neckers, Chem. Mater. 1991, 3, 858-8641.

WO 2020/245456 A1 discloses a process, an apparatus and photoswitchable photoinitiators for locally polymerizing a starting material by dual color photopolymerization and method for volumetric printing of a shaped body. Disclosed are inter alia dual color photoinitiators, which respond to electromagnetic radiation of a first wavelength by switching from a thermodynamically stable state A to a metastable state B. B is able to absorb electromagnetic radiation of a second wavelength, thereby forming C, that can initiate a polymerization reaction. B can undergo a thermal reverse reaction to the form A and is then deactivated for electromagnetic radiation of the second wavelength. Application of such dual color photoinitiators allows the curing of a photopolymerizable resin in any volume, where electromagnetic radiation of both wavelengths intersects, for example where an image is projected on a light sheet. A thermal back reaction and no curing with the first wavelength alone is desirable for preventing curing in unwanted areas.

Derivatives of [1,2-b]naphthopyran have been shown to respond to step-wise dual color irradiation in European Polymer Journal, 2023, 196, 112312. The disclosed examples suffer from low reactivity and no application in volumetric printing to form complex three-dimensional objects has been shown. Furthermore, the two-dimensional objects which have been prepared using derivatives of [1,2-b]naphthopyran are deeply colored.

Derivatives of [1,2-b]naphthopyran can be substituted in their R¹ and/or R⁴ position as has been shown in Chem. Commun., 2015,51, 3057-3060. Such a substitution results in a suppression of a long lasting colored isomer, which is beneficial for naphthopyran derivatives in general. Dual color polymerization employing such derivatives has not been disclosed.

It is, therefore, the object of the present invention to overcome the disadvantages of the currently available methods as discussed above. More particular, it is the object of the present invention to provide efficient photoinitiator molecules with improved reactivity towards dual color irradiation in comparison to photoinitiators known from the prior art and their application in the formation of colorless and complex three-dimensional objects.

### Summary of the invention

For the solution, a process for local polymerization of a starting material by means of dual color photopolymerization according to the independent claim 1 and the use a photoinitiator molecule in a process for locally polymerizing a starting material by dual color photopolymerization according to independent claim 17 are provided. Further embodiments are subject to dependent claims.

According to one aspect, a process for local polymerization of a starting material by means of dual color photopolymerization is provided. Here a polymerizable starting material is provided which contains photoinitiator molecules which can be converted by means of sequential optical excitation with light of at least two, preferably two different wavelengths into a reactive state in which the photoinitiator molecules locally trigger a polymerization of the starting material, in particular a local curing or hardening of the starting material due to the polymerization. The starting material is photopolymerized in a local volume by irradiating light of a first wavelength simultaneously with or followed by light of a second wavelength different from the first wavelength into the local volume.

In the local volume is provided that, by absorption of a photon of the first wavelength, the photoinitiator molecules are converted from an initial state, in which the photoinitiator molecules do not substantially absorb the light of the second wavelength, to an intermediate state with optical properties different from those of the initial state, in such a way that the photoinitiator molecules in the intermediate state absorb the light of the second wavelength and enter the reactive state. In the local volume, due to the gradual absorption of the light of the first wavelength and the light of the second wavelength, the photoinitiator molecules are transferred from the initial state via the intermediate state into the reactive state, which locally triggers polymerization. Outside of the local volume the photoinitiator molecules which have been in the intermediate state return to the initial state.

According to another aspect, an apparatus for local polymerization of a starting material by means of dual color photopolymerization is created. The apparatus comprises the following: an intake for a polymerizable starting material, light generating means arranged to provide light of a first wavelength and light of a second wavelength, the second wavelength being different from the first wavelength, and light guide means arranged to irradiate the light of the first wavelength and the light of the second wavelength into a local volume. The apparatus is arranged to perform the following processes: taking up the polymerizable starting material by the intake, the starting material containing photoinitiator molecules which can be converted by means of sequential optical excitation into a reactive state in which the photoinitiator molecules locally trigger polymerization of the starting material, and thus result in photopolymerization of the starting material in a local volume by means of irradiation of the light of the first wavelength and the light of the second wavelength in a defined local volume. The following is provided in the local volume: the photoinitiator molecules are converted from an initial state, in which the photoinitiator molecules essentially do not absorb the light of the second wavelength, into an intermediate metastable ground state with changed optical properties compared to the initial state due to absorption of a photon of the first wavelength, in such a way that the photoinitiator molecules in the intermediate state absorb the light of the second wavelength. In the local volume, due to the gradual absorption of light of the first wavelength and light of the second wavelength, the photoinitiator molecules are converted from the initial state via the intermediate state into the reactive state, which locally triggers polymerization. Outside of the local volume the photoinitiator molecules which have been in the intermediate state return to the initial state.

Furthermore, a method for volumetric-printing of a shaped body is provided, in which the shaped body is produced by means of the method for local polymerisation of the starting material, wherein the local photopolymerisation leads to hardening or curing of the starting material and thus to production of the shaped body.

The absorptive capacity of the photoinitiator molecules in the intermediate state with respect to light of the second wavelength can be based on a change in the optical properties of the photoinitiator molecules, by which the absorptive capacity for light of the second wavelength is initially formed, in particular in that a spectral absorption band is formed in the region of the second wavelength due to the transition from the initial state to the intermediate state. Alternatively, it can be provided that an absorption band for light of the second wavelength already existing in the initial state of the photoinitiator molecules is amplified or enlarged in the intermediate state.

In the intermediate state, the photoinitiator molecules in the range of the first wavelength may be still absorbing or no longer absorbing. Further preferred, the photoinitiator molecules in the intermediate state may be substantially less absorbing in the range of the first wavelength than in the range of the second wavelength. More preferred, the photoinitiator molecules in the intermediate state may substantially not absorb the light of the first wavelength. Most preferred, the photoinitiator molecules in the intermediate state may not absorb the light of the first wavelength.

In one aspect, the intermediate state may return thermally at the printing temperature in the printing resin to the initial state. Preferably, the intermediate state may return thermally at the printing temperature to the initial state in a mechanism with one or more rate constants with the highest rate constant higher than k=0.01 s-1. Especially preferably, at least one rate constant for the thermal back reaction is higher than 0.02 s⁻¹. more preferably, higher than 0.05 s⁻¹, even more preferably higher than 0.08 s⁻¹, Most preferably higher than 0.25 s⁻¹, but optionally not higher than 0.65 s⁻¹ Hence, the rate constant may be in the range of 0.1 s⁻¹ and 0.65 s⁻¹, or any other range which may be formed from the values above.

In the various embodiments, local photopolymerization in the local area can lead to hardening or curing of the starting material.

Light of the first and second wavelength can be irradiated simultaneously into the local volume.

Light of the second wavelength can be irradiated into the local volume after the irradiation of the light of the first wavelength into the local volume has ended, the light of the second wavelength being irradiated before the end of a decay time of the intermediate state of the photoinitiator molecules.

Due to the absorption of light of the second wavelength, the photoinitiator molecules can be converted into a reactive state, which triggers polymerization in the local volume. It may be intended that this reactive state is produced in analogy to a Norrish type I reaction or a Norrish type II reaction which is known to the skilled person. Alternatively, it may be intended that this reactive state undergoes an electron transfer reaction with a co-initiator.

Disclosed are further dual color photoinitiators, which respond to electromagnetic radiation of a first wavelength by switching from a thermodynamically stable state A to a metastable state B. B is able to absorb electromagnetic radiation of a second wavelength, thereby forming C, that can initiate a polymerization reaction with or without a co-initiator. B can undergo a thermal reverse reaction to the form A and may then be deactivated for electromagnetic radiation of the second wavelength. Application of such dual color photoinitiators may allow the curing of a photopolymerizable resin in any volume, where electromagnetic radiation of both wavelengths intersects, for example where an image may be projected on a light sheet. The disclosed substitution patterns ensure a thermal back reaction and limited or no curing with the first wavelength alone, preventing the curing in unwanted areas. Application of the disclosed dual color photoinitiators in a polymerizable mixture allows fast volumetric printing with high resolution. No support structures are required, which saves material and allows for the fabrication of soft and fragile products. A broad range of possible resin viscosities can be covered, and high reactivity is achieved, due to minimized quenching of the polymerization by oxygen and water. The utilization of the disclosed dual color photoinitiators allows faster printing than common photopolymerization based additive manufacturing techniques due to fewer mechanical operations.

The disclosed dual color photoinitiators may be characterized in a way that a polymerization may be induced where electromagnetic radiation of at least two, preferably two different wavelengths interact with the same volume of polymerizable material in a simultaneous or consecutive fashion. In volumes which interact with electromagnetic irradiation of only one wavelength, less or no polymerization may be induced.

Due to the absorption of the light of the second wavelength, the photoinitiator molecules can be converted into a reactive state which triggers a radical polymerization in the local volume.

A light beam of light of the first wavelength and a light beam of light of the second wavelength can be irradiated in the local volume at least partially overlapping.

The starting material can be polymerized in several local volumes by means of photo polymerization and thus a three-dimensional shaped body can be produced in the starting material.

Without being bound by any theory, a dual color photoinitiator in the thermodynamically stable form A may absorb a photon from electromagnetic radiation of the first wavelength which induces an isomerization reaction to the metastable form B. The dual color photoinitiator in the metastable form B may absorb a photon from electromagnetic radiation of the second wavelength, which results in an excited state C and may further cause the formation of radicals by hydrogen abstraction from a co-initiator followed by electron transfer or decomposition into radicals, by electron transfer which is followed by hydrogen abstraction or decomposition into radicals, or homolytic bond cleavage which can be preceded or followed by other rearrangement reactions to form radicals. Dual color photoinitiators in the metastable state B which have not absorbed a photon from electromagnetic radiation of the second wavelength, may return spontaneously via a thermal process to the thermodynamically stable state A.

The dual color photoinitiators may provide efficient switching to the merocyanine form and therefore may show little or no curing with UV light alone. Electromagnetic radiation of the first wavelength causes excitation of the initiator in form A and switching to the initiator in form B. The efficient ring opening reaction of the photoswitch motif may prevent the dual color photoinitiators from radical formation by irradiation with the first wavelength alone. The merocyanine type form B may act as an internal triplet sensitizer upon irradiation with the second wavelength, which may cause the carbonyl group to abstract a hydrogen atom from a co-initiator, undergo an electron transfer reaction, or undergo homolytic bond cleavage. Alternatively, the merocyanine type form B can undergo an electron transfer reaction with the co-initiator from the singlet excited state. The substituents may be selected in a way to minimize or extinguish the absorption of the merocyanine type form B at the first wavelength and that form B is thermodynamically destabilized to ensure a thermal back reaction from B to A. Substituents are also chosen in a way to adjust the photo redox potential to the respective co-initiator if present. Furthermore, the dual color photoinitiators may benefit from an exceptionally low or neglectable quantum yield for the competing photoreaction from B to A and high extinction coefficients of the B form, where form A does not absorb. The merocyanine form B may typically have a broad absorption in the visible region, which allows for high intensities over a broad range of wavelengths.

The photoinitiator molecule, and its necessary function can be produced in different ways. One example provides the following:

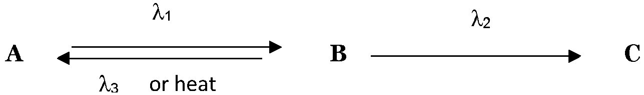

The photoinitiator can exist in three different states, which may be characterized as follows:
Initial state (A):
   - Without light irradiation the photoinitiator molecules are present in this state. The naphthopyran of formula (1) may be the initial state (A).
Intermediate state (B):
   - The B state is an electronic ground state. The corresponding merocyanine form of naphthopyran of formula (1) may be the intermediate state B.
   - The intermediate state is created from the initial state A by absorption of light of wavelength λ₁.
   - The photoinitiator molecules have a new or more intense absorption band for light of wavelength λ₂.
   - Alternatively, the absorption band for λ₁ disappears. The photoinitiator molecule returns to the initial state A spontaneously in the absence of light or by absorption of light of wavelength λ₃.
Reactive state (C):
   - The reactive state is generated from the intermediate state B by absorption of light of wavelength λ₂.
   - The reactive state initiates a polymerization reaction in the immediate vicinity of the molecule.
   - A back reaction to B is not intended.

In another aspect, the present invention discloses a process for locally polymerizing a starting material by using a naphthopyran according to the present invention as a photoinitiator and irradiating the naphthopyran with two light of at least two different wavelengths.

In yet another aspect, the present invention discloses a process for locally polymerizing a starting material by dual color photopolymerization, comprising:
- providing a polymerizable starting material containing photoinitiator molecules wherein the photoinitiator molecule is a naphthopyran according to the present invention which can be converted by sequential optical excitation into a reactive state in which the photoinitiator molecules locally trigger polymerization of the starting material; and
   - photopolymerizing the starting material in a local volume by irradiating light of a first wavelength and light of a second wavelength, different from the first wavelength, into the local volume, whereby in the local volume
   - the photoinitiator molecules are converted, due to the absorption of the light of the first wavelength, from an initial state in which the photoinitiator molecules substantially do not absorb the light of the second wavelength, into an intermediate state with changed optical properties compared to the initial state, such that the photoinitiator molecules in the intermediate state absorb the light of the second wavelength; and
- the photoinitiator molecules are transferred from the intermediate state to the reactive state due to the absorption of the light of the second wavelength, which triggers the polymerization locally, and / or
- the photoinitiator molecules may be transferred from the intermediate state to the initial state spontaneously in a thermal reaction.

The photoinitiator molecule which is used in the process for locally polymerizing a starting material by dual color photopolymerization according to the invention is represented by one of the following formula (Ib) 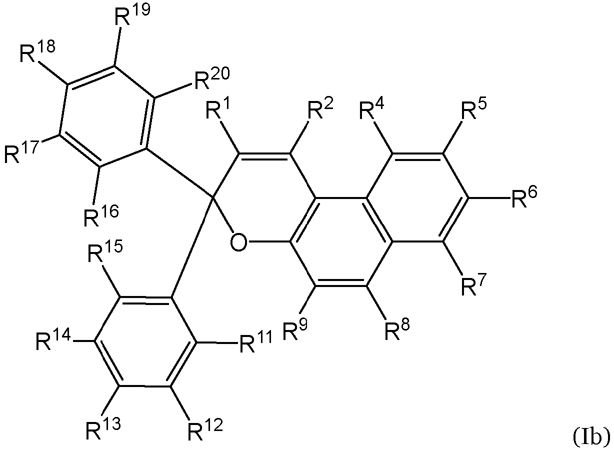 wherein
R¹, R², R⁴ to R⁹, and R¹¹ to R²⁰ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 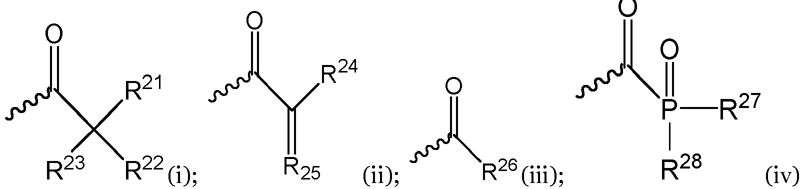 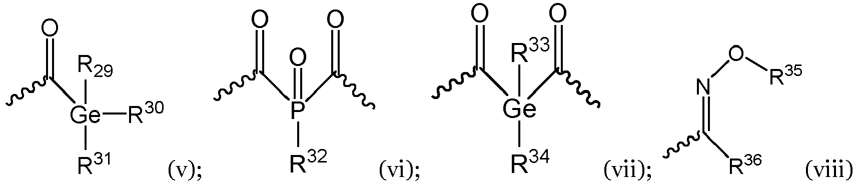
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or R¹⁵ and R¹⁶ form together a single bond to form a structure of the following formula 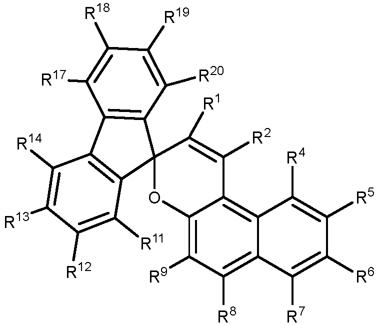 and the remaining R¹, R², R4 to R⁹, and R¹¹ to R¹⁴ and R¹⁷ to R³⁶ are selected as above
wherein
the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
   and
two adjacent groups of R¹, R², R⁴ to R⁹, and R¹¹ to R³⁶ may be linked to each other to form a substituted or unsubstituted fused ring structure, preferably, a substituted or unsubstituted fused aromatic C₆-ring, wherein the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

Preferably, R¹ and R² are H or D, preferably H; and
at least one of R⁴ to R⁹, and R¹¹ to R²⁰ are independently selected from the group consisting of halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 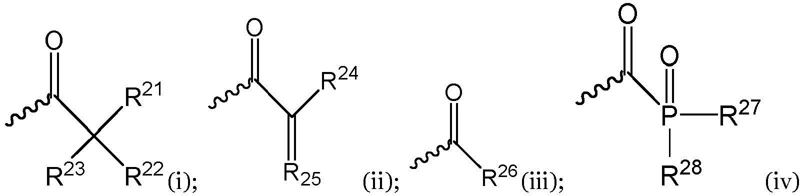 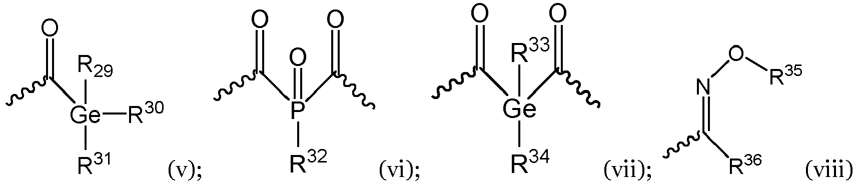
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or R¹⁵ and R¹⁶ form together a single bond to form a structure of the following formula 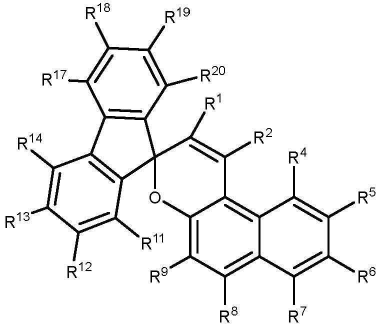 and the remaining R¹, R², R⁴ to R⁹, and R¹¹ to R¹⁴ and R¹⁷ to R³⁶ are selected as above
wherein
the one or more substituents, if present in one or more of R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
   and
two adjacent groups of R⁴ to R⁹, and R¹¹ to R³⁶ may be linked to each other to form a substituted or unsubstituted fused ring structure, preferably, a substituted or unsubstituted fused aromatic C₆-ring, wherein the one or more substituents, if present in one or more of R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

Preferably, at least one of R⁵, R⁶, R⁸, R¹³, and R¹⁸ is independently selected from the group consisting of halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 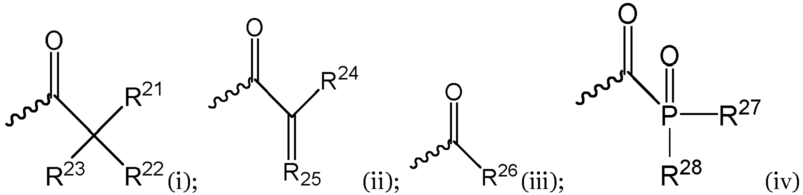 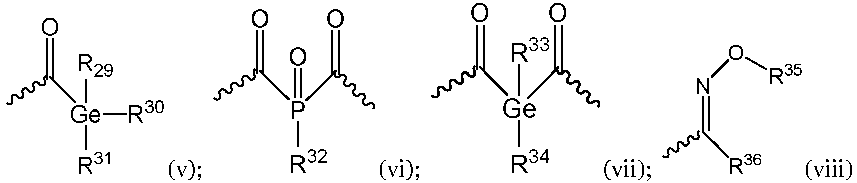
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or R¹⁵ and R¹⁶ form together a single bond to form a structure of the following formula 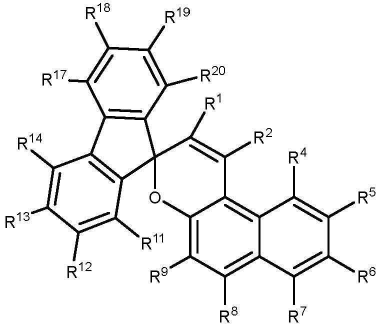 and the remaining R¹, R², R⁴ to R⁹, and R¹¹ to R¹⁴ and R¹⁷ to R³⁶ are selected as above
wherein
the one or more substituents, if present in one or more of R⁵, R⁶, R⁸, R¹³, R¹⁸ and R²¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
   and
two adjacent groups of R²¹-R³⁶ may be linked to each other to form a substituted or unsubstituted fused ring structure, preferably, a substituted or unsubstituted fused aromatic C₆-ring, wherein the one or more substituents, if present in one or more of R²¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

Preferably, R¹, R², R⁴ to R⁹, and R¹¹ to R²⁰ are independently selected from the group consisting of H; D; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, wherein R' is independently selected from the group consisting of substituted or unsubstituted C₁-C₂₀-alkyl, substituted or unsubstituted C₁-C₂₀-hetero alkyl, , two R' may form a ring structure; and the following structures (i) or (iii) 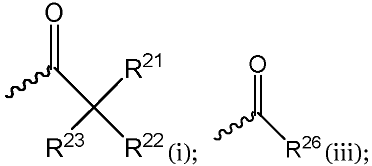
wherein R²¹ to R²³ and R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
wherein
the one or more substituents, if present in one or more of R¹, R², R⁴ to R⁹, and R¹¹ to R²³ and R³⁶, are independently selected from the group consisting of D; halogen; substituted or unsubstituted C₂-C₄₉-aryl acyl; and substituted or unsubstituted C₂-C₄₉-aryl ester;
   and
two adjacent groups of R¹, R², R⁴ to R⁹, and R¹¹ to R²³ may be linked to each other to form a substituted or unsubstituted fused ring structure, preferably, a substituted or unsubstituted fused aromatic C₆-ring, wherein the one or more substituents, if present in one or more of R¹ to R²³, are independently selected from the group consisting of D; halogen; substituted or unsubstituted C₂-C₄₉-aryl acyl; and substituted or unsubstituted C₂-C₄₉-aryl ester
or R¹⁵ and R¹⁶ form together a single bond to form a structure of the following formula 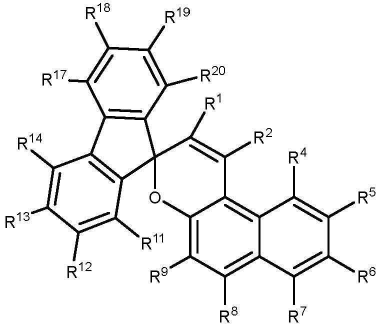 and the remaining R¹, R², R⁴ to R⁹, and R¹¹ to R¹⁴ and R¹⁷ to R³⁶ are selected as above .

Preferably R¹ and/or R⁴ are independently selected from the group consisting of halogen; CN; substituted or unsubstituted C₁-C₂₀-alkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; substituted or unsubstituted sulfonic acids and salts thereof; substituted or unsubstituted C₂-C₂₀-alkynyl, substituted or unsubstituted C₂-C₂₀-alkenyl; more preferably Br; substituted or unsubstituted C₁-C₂₀-alkyl; substituted or unsubstituted C₆-C₁₀-aryl; substituted or unsubstituted C₁-C₂₀ alkyl amide; substituted or unsubstituted C₆-C₄₈-aryl amide; most preferably R¹ is substituted or unsubstituted C₆-C₁₀-aryl.

Preferably, R⁸ and R⁹ are linked to each other to form a substituted or unsubstituted fused ring structure.

Preferably R⁶ and R⁷ are linked to each other to form a substituted or unsubstituted fused ring structure.

Preferably, at least one of R¹, R², R⁴ to R⁹, and R¹¹ to R²⁰ is selected from the following structures (i) to (viii) 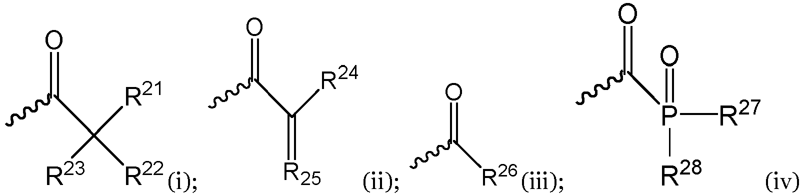 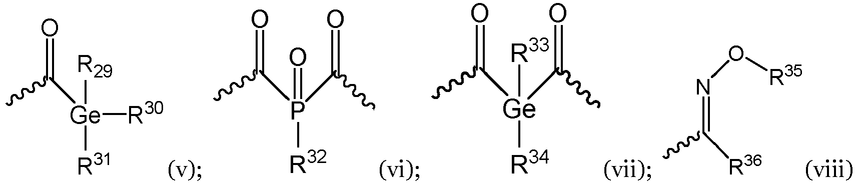
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or R¹⁵ and R¹⁶ form together a single bond to form a structure of the following formula 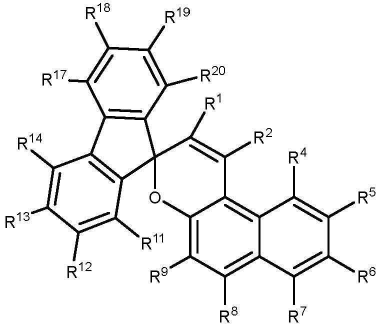 and the remaining R¹, R², R⁴ to R⁹, and R¹¹ to R¹⁴ and R¹⁷ to R³⁶ are selected as above
wherein
the one or more substituents, if present in one or more of R²¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
   and
two adjacent groups of R²¹-R³⁶ may be linked to each other to form a substituted or unsubstituted fused ring structure, preferably, a substituted or unsubstituted fused aromatic C₆-ring, wherein the one or more substituents, if present in one or more of R²¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

Preferably, at least one of R¹, R², R⁴ to R⁹, and R¹¹ to R²⁰ is selected from the following structures (i) and (iii) 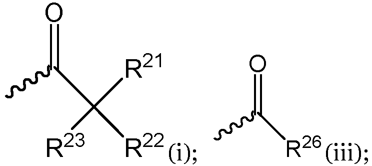
wherein R²¹ to R²³ and R²⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or R¹⁵ and R¹⁶ form together a single bond to form a structure of the following formula 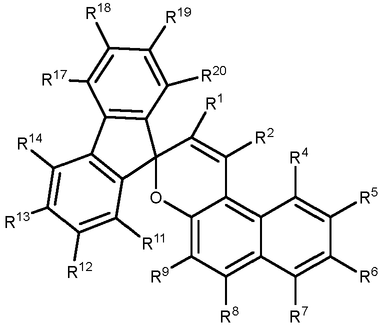 and the remaining R¹, R², R⁴ to R⁹, and R¹¹ to R¹⁴ and R¹⁷ to R³⁶ are selected as above
wherein
the one or more substituents, if present in one or more of R²¹ to R²³ and R²⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
   and
two adjacent groups of R²¹ to R²³ and R²⁶ may be linked to each other to form a substituted or unsubstituted fused ring structure, preferably, a substituted or unsubstituted fused aromatic C₆-ring, wherein the one or more substituents, if present in one or more of R²¹ to R²³ and R²⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

Preferably, at least one of, more preferably one of R⁴ to R⁹, even more preferably one of R⁵, R⁶ R⁸ is selected from the following structures (i) and (iii) 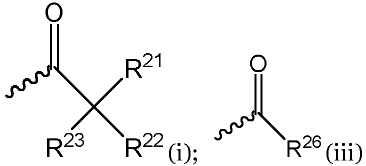
wherein R²¹ to R²³ and R²⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or R¹⁵ and R¹⁶ form together a single bond to form a structure of the following formula 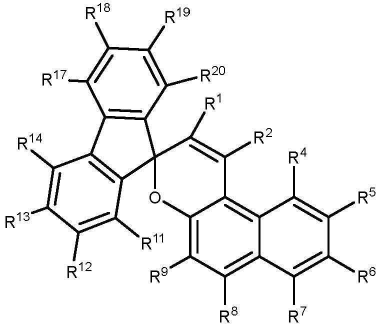 and the remaining R¹, R², R⁴ to R⁹, and R¹¹ to R¹⁴ and R¹⁷ to R³⁶ are selected as above
wherein
the one or more substituents, if present in one or more of R²¹ to R²³ and R²⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
   and
two adjacent groups of R²¹ to R²³ and R²⁶ may be linked to each other to form a substituted or unsubstituted fused ring structure, preferably, a substituted or unsubstituted fused aromatic C₆-ring, wherein the one or more substituents, if present in one or more of R²¹ to R²³ and R²⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

Preferably, at least one, more preferably one of R¹, R², R⁴ to R⁹, and R¹¹ to R²⁰ is independently selected from the group consisting of 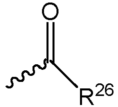 (iii) or an electron withdrawing group, wherein R²⁶ is defined as in one of the above preferred embodiments.

Preferably one of R¹, R², R⁴ to R⁹, and R¹¹ to R²⁰ is independently selected from the group consisting of 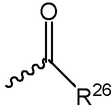 (iii) or an electron withdrawing group, wherein R²⁶ is defined as in one of the above preferred embodiments.

Preferably, at least one of, preferably one of R⁵, R⁶ and R⁸ is independently selected from the group consisting of 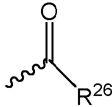 (iii) or an electron withdrawing group wherein R²⁶ is defined as in one of the above preferred embodiments.

Preferably, at least one of R¹ to R²⁰ is

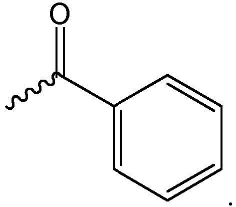

Preferably, one of R¹ to R²⁰ is

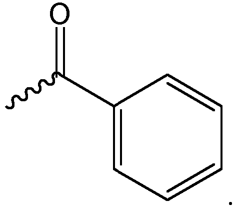

Preferably, R¹ and/or R⁴ are independently selected from the group consisting of halogen; CN; substituted or unsubstituted C₁-C₂₀-alkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; substituted or unsubstituted sulfonic acids and salts thereof; substituted or unsubstituted C₂-C₂₀-alkynyl, substituted or unsubstituted C₂-C₂₀-alkenyl; more preferably Br; substituted or unsubstituted C₁-C₂₀-alkyl; substituted or unsubstituted C₆-C₁₀-aryl; substituted or unsubstituted C₁-C₂₀ alkyl amide; substituted or unsubstituted C₆-C₄₈-aryl amide; most preferably R¹ is substituted or unsubstituted C₆-C₁₀-aryl.Preferably, at least one of R³ to R¹⁰ and at least one of R¹¹ to R²⁰ is independently selected from the group consisting of 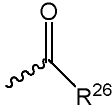 (iii) or an electron withdrawing group.

Preferably, one of R³ to R¹⁰ and one of R¹¹ to R²⁰ is independently selected from the group consisting of 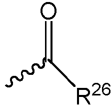 (iii) or an electron withdrawing group.

Preferably, one of R³ to R¹⁰ and one of R¹¹ to R²⁰ is

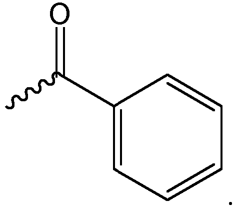

Preferably, one of R⁶ and R¹³ is

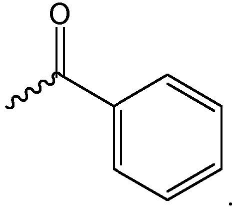

Preferably, at least one of, more preferred one of R⁵, R⁶ and R⁸ is

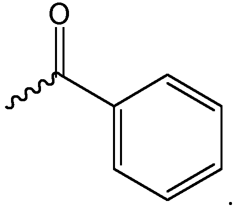

In one embodiment of the invention, R¹ to R²⁰ are each H.

Preferably, the photoinitiator molecule has the formula PM-1 to PM-5

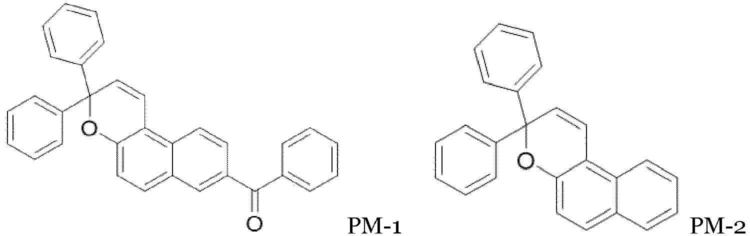

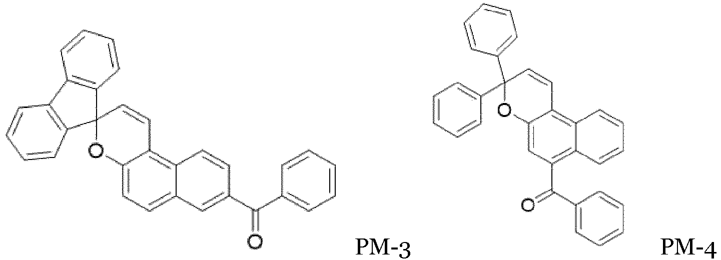

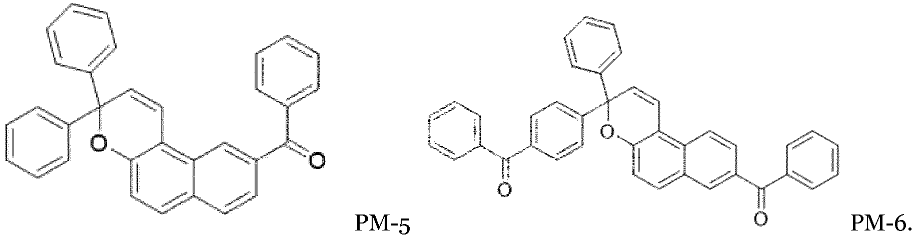

The object is further achieved by the use of a photoinitiator molecule in a process for locally polymerizing a starting material by dual color photopolymerization;
wherein
the photoinitiator molecule is represented by one of the following formulas (Ib) 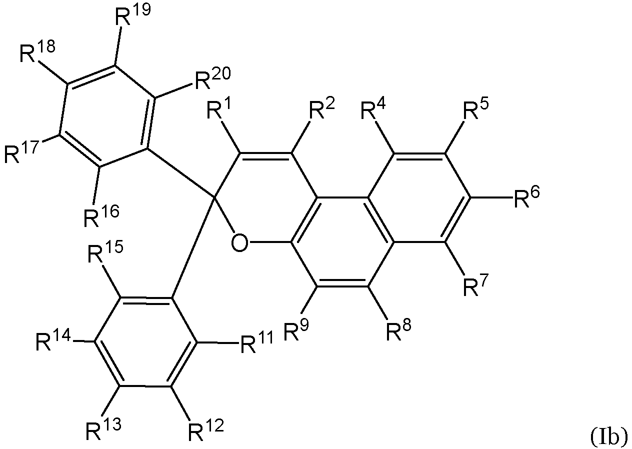
wherein
R¹, R², R⁴ to R⁹, and R¹¹ to R²⁰ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 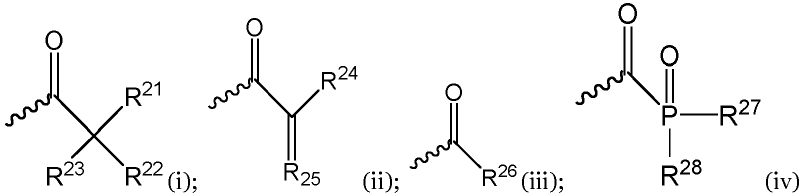 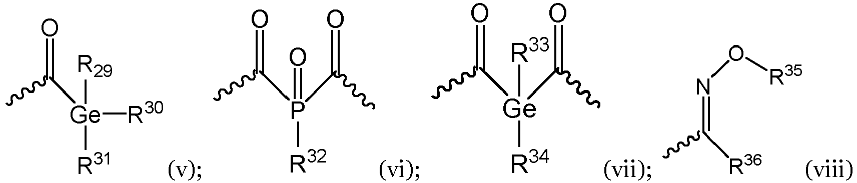
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or R¹⁵ and R¹⁶ form together a single bond to form a structure of the following formula 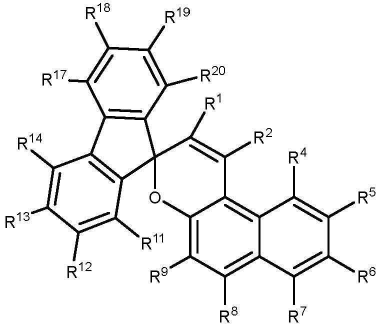 and the remaining R¹, R², R⁴ to R⁹, and R¹¹ to R¹⁴ and R¹⁷ to R³⁶ are selected as above
wherein
the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
   and
two adjacent groups of R¹, R², R⁴ to R⁹, and R¹¹ to R³⁶ may be linked to each other to form a substituted or unsubstituted fused ring structure, preferably, a substituted or unsubstituted fused aromatic C₆-ring, wherein the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

Preferred embodiments for the use of a photoinitiator molecule in the process for locally polymerizing a starting material by dual color photopolymerization according to the invention are the same as that set forth above with respect to the process according to the invention.

According to a further aspect, the invention is related to an apparatus for locally polymerizing a starting material by dual color photopolymerization, comprising:
- an intake for a polymerizable starting material;
- light generating means arranged to generate light of a first wavelength and light of a second wavelength, the second wavelength being different from the first wavelength; and
- a light guide device arranged to irradiate the light of the first wavelength and the light of the second wavelength into a local volume;

said device being adapted to perform the following procedure:
   - taking up the polymerizable starting material by said intake, said starting material containing photoinitiator molecules which can be excited by sequential optical excitation into a reactive state in which the photoinitiator molecules locally initiate polymerization of the starting material; and
   - photopolymerizing the starting material in a local volume by irradiating the light of the first wavelength and the light of the second wavelength into the local volume, whereby in the local volume
   - the photoinitiator molecules, due to the absorption of the light of the first wavelength, are converted from an initial state in which the photoinitiator molecules substantially do not absorb the light of the second wavelength into an intermediate state with changed optical properties compared to the initial state, such that the photoinitiator molecules in the intermediate state absorb the light of the second wavelength; and
   - the photoinitiator molecules are transferred from the intermediate state to the reactive state due to the absorption of the light of the second wavelength, which triggers the polymerization locally;
wherein
the photoinitiator molecule is represented by one of the following formula (Ib) 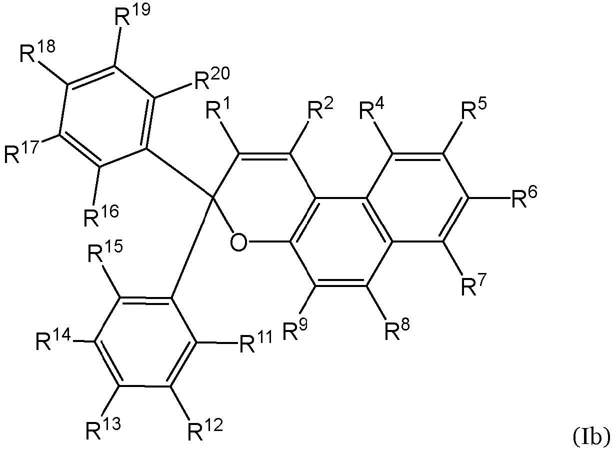
wherein
R¹, R², R⁴ to R⁹, and R¹¹ to R²⁰ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 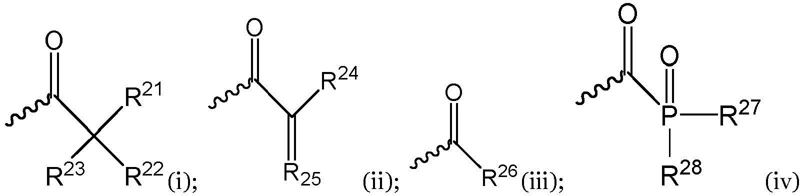 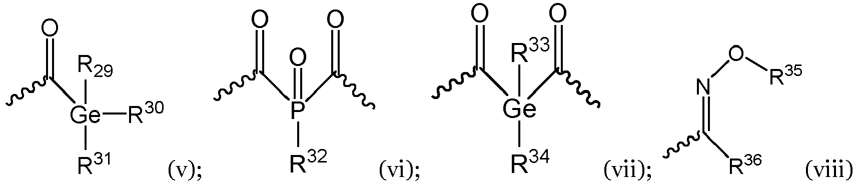
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or R¹⁵ and R¹⁶ form together a single bond to form a structure of the following formula 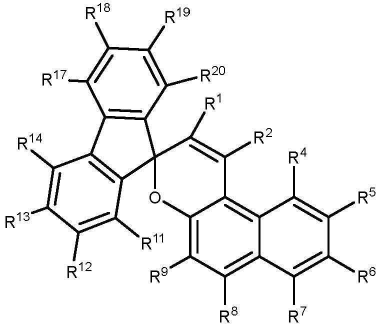 and the remaining R¹, R², R⁴ to R⁹, and R¹¹ to R¹⁴ and R¹⁷ to R³⁶ are selected as above
wherein
the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
   and
two adjacent groups of R¹, R², R⁴ to R⁹, and R¹¹ to R³⁶ may be linked to each other to form a substituted or unsubstituted fused ring structure, preferably, a substituted or unsubstituted fused aromatic C₆-ring, wherein the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

Preferred embodiments for the apparatus for locally polymerizing a starting material by dual color photopolymerization according to the invention are the same as that set forth above with respect to the process according to the invention.

According to the present disclosure, halogen may be fluorine, chlorine, bromine, iodine, especially fluorine.

According to the present disclosure, alkyl, alkenyl, and alkynyl may be cyclic, linear, or branched.

According to the present disclosure, alkyl acyl has the following formula 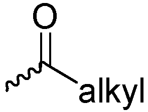 and arylacyl has the following formula 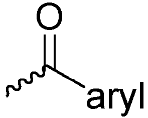 wherein the waved line represents the bond of the acyl group to the structure of formula (Ib)

In the case that one (or more) of the groups R¹, R², R⁴ to R⁹, and R¹¹ to R²⁰ is selected as amide, the bond can be made via the N as well as via the CO.

In the case that one (or more) of the groups R¹, R², R⁴ to R⁹, and R¹¹ to R²⁰ is selected as ester, the bond can be made via the O as well as via the CO.

In one embodiment, one of R¹, R², R⁴ to R⁹, and R¹¹ to R²⁰ is substituted or unsubstituted C₂-C₄₉-arylacyl and the remaining R¹, R², R⁴ to R⁹, and R¹¹ to R²⁰ are H.

In a further embodiment, R¹, R², R⁴ to R⁹, and R¹¹ to R²⁰ are independently selected from the group consisting of H, D, halogen, NO₂, CN, substituted or unsubstituted C₂-C₄₉-alkyl acyl; substituted or unsubstituted C₂-C₄₉-arylacyl, substituted or unsubstituted aryl, NH₂, and OH, wherein the one or more substituents, if present, are selected from halogen, NO₂, CN, NH₂, NMe₂, OMe, CF₃, and OH.

In a further embodiment, it is provided that R¹, R², R⁴ to R⁹, and R¹¹ to R²⁰ are independently selected from the group consisting of H and electron withdrawing group.

The electron withdrawing group may be CN, F, NO₂, ester groups, acyl groups, SO₂R, such as SO₂CF₃, SO₂Me, or SO₂NH₂, SF₅, NR₃⁺, pyridinium, halogen, and fluorinated alkyls or aryls, such as CF₃.

In a preferred embodiment, the group of electron withdrawing substituents or electron withdrawing groups contains substituents which are more electron withdrawing in reference to hydrogen (H). The skilled person may refer to: "A survey of Hammett substituent constants and resonance and field parameters", Chem. Rev. 1991, 91, 2, 165-195, which lists electron withdrawing groups and electron withdrawing substituents.

In all embodiments in which one or more of the groups R¹ to R³⁶ are selected from halogen or substituted with halogen, it may be provided that the halogen is F (fluorine).

In one embodiment at least one of R¹, R², R⁴ to R⁹, and R¹¹ to R²⁰ is independently selected from the group consisting of electron donating groups, alternatively alkoxy, alternatively methoxy and at least one of R¹ to R²⁰ is selected from unsubstituted or substituted arylacyl; or unsubstituted or substituted alkylacyl.

The electron donating groups may be SH, SR, OH, OR, NH₂, NHR, and NR₂,

In a preferred embodiment, the group of electron donating substituents or electron donating groups contains substituents which are more electron donating in reference to hydrogen (H). The skilled person may refer to: "A survey of Hammett substituent constants and resonance and field parameters", Chem. Rev. 1991, 91, 2, 165-195, which lists electron donating groups and electron donating substituents.

In one particular embodiment it may be provided that one of R¹, R², R⁴ to R⁹, and R¹¹ to R²⁰, such as R⁵, R⁶ or R⁸, is independently selected from the group consisting of CF₃, SO₂Me, SO₂NH₂, CN, F, NO₂, C₆-aryl, unsubstituted C₆-arylacyl of the following formula 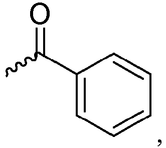 dimethoxy-substituted arylacyl of the formula 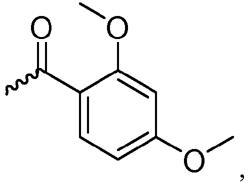 methoxy-substituted arylacyl of the formula 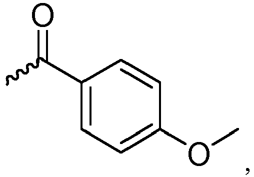 fluorine-substituted arylacyl of the following formula 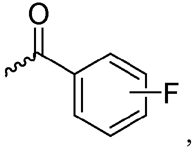 alternatively of the formula 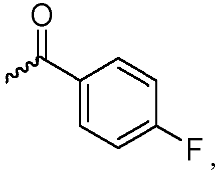 and C₆-aryl.

In an embodiment, the photoinitiator molecule may be linked to a polymerizable group. The polymerizable group may be seleced from the group consisting of (meth)acrylate, acrylamide, vinylether, and vinylester, preferably (meth)acrylate.

In another embodiment, two or more photoinitiator molecules may be linked to each other by a linker group. The chemical bond(s) to the linker group may be independently established by any of R¹-R²⁰.

The photoinitiator may comprise one or more of the compounds, or the photoinitiator consists of one or more of the compounds.

According to the invention, it may be intended that two or more of the above-mentioned embodiments are combined with each other.

Due to the absorption of the light of the second wavelength, the photoinitiator molecules can be converted into a reactive state which triggers a radical polymerization in the local volume.

A light beam of light of the first wavelength and a light beam of light of the second wavelength can be irradiated in the local volume at least partially overlapping.

The starting material can be polymerized in several local volumes by means of photo polymerization and thus a three-dimensional shaped body can be produced in the starting material.

The naphthopyran of formula (Ib) shown above may be used in connection with the process for locally polymerizing a starting material by dual color photopolymerization. The same applies to the process for 3D-printing of the molded body or the method for volumetric printing of a shaped body.

Formulations suitable for volumetric printing may contain the following parts by weight:
- 1 -99.9999 wt%, preferably 5-99.99 wt%, more preferably 20-99.9 wt% of photopolymerizable compound(s), e.g. monomer(s);
- 0-99wt%, preferably 1-50 wt%, more preferably 3-20 wt% co-initiator, when the co-initiator contains photopolymerizable groups, e.g. acrylates;
- 0-50wt%, preferably 1-40 wt%, more preferably 3-10 wt% of co-initiator, when the co-initiator does not contain photopolymerizable groups;
- 0.0001-20 wt%, preferably 0.001-10 wt%, more preferably 0.01-5 wt%, most preferably 0.1-1 wt% of a naphthopyran of formula (1) which may be used a dual color photoinitiator;
- 0-20 wt%, preferably 1-10 wt%, more preferably 3-5 wt% of acids or bases;
- 0-90 wt%, preferably 1-70 wt%, more preferably 5-50 wt%, most preferably 10-30 wt% of other additives, such as organic or inorganic fillers, optical brighteners, inhibitors, chain transfer agents and others; and
- 0- 90 wt%, preferably 5-50 wt%, more preferably 10-30 wt% of solvent.

All weight ratios are given with respect to the weight of the total formulation.

Typical curing parameters which are suitable for volumetric printing may be:
- any setup which employs light of two different wavelengths;
- a temperature of -20 °C to +100 °C; preferably 0 °C to +60 °C, more preferably +20 °C to + 60 °C
- a first wavelength of: 250 nm to 500 nm; preferably, 300 nm to 450 nm; more preferably 360 nm to 420 nm and
- a second wavelength of: 350 nm to 800 nm, preferably 400 nm to 750 nm, more preferably 420 nm to 700 nm, most preferably 450 nm to 600 nm.

Preferably, the photoinitiator molecule is a naphthopyran as disclosed in the present invention.

Preferably, a local volume may be a container.

Preferably, an intake may be a container.

Preferably, the first wavelength is smaller than the second wavelength.

Preferably, the light of the first wavelength is irradiated as a light sheet and the light of the second wavelength is irradiated as a projection of a 2D-image, wherein the first wavelength is smaller than the second wavelength. The light sheet of the light of the first wavelength and the light projection of the light of the second wavelength may at least partially overlap in the local volume, preferably container, when irradiated.

Surprisingly, it has been found, that the dual color effect can be significantly improved, when the first wavelength is smaller than the second wavelength. While simple objects may be formed with a second wavelength being smaller than the first wavelength, complex objects are of higher structure fidelity, when printed with a first wavelength being smaller than a second wavelength. Interestingly, such an effect has not been observed for resins based on alpha-diketone photoinitiators, which are known from the state of the art (Nature Photonics, 2022, 16, 784-791). For alpha-diketone photoinitiators no curing is observed when the light sheet of first wavelength is smaller than the projection ofdm the second wavelength.

Preferably, the first wavelength is in the UV region and the second wavelength is in the visible region.

Preferably, the container may be at least partially transparent. Hence, the container is configured to at least partially transmit light of the first wavelength and light of the second wavelength from the source into the container so that a polymerization reaction may be locally triggered. The container may contain a rectangular surface, preferably the container has a rectangular cuboid shape, more preferably a cubic shape.

The container may cover a volume of at least 0.1 cm × 0.1 cm × 0.1 cm, preferably at least 0.5 cm × 0.5 cm × 0.5 cm, more preferably at least 1 cm × 1 cm × 1 cm, even more preferably at least 1.5 cm × 1.5 cm × 1.5 cm, still more preferably at least 3 cm × 3 cm × 3 cm, most preferably at least 5 cm × 5 cm × 5 cm.

Preferably, the light of the first wavelength and the light of the second wavelength are simultaneously irradiated into the local volume. In an alternative embodiment, the light of the second wavelength may be irradiated into the local volume after the irradiation of the light of the first wavelength in the local volume has ended, while the light of the second wavelength may be irradiated before the end of a decay time of the intermediate state of the photoinitiator molecules.

Furthermore, preferably, the photoinitiator molecules in the intermediate state substantially do not absorb the light of the first wavelength.

Preferably, the photoinitiator molecules in the initial state have an extinction coefficient at the second wavelength which is lower than 2000 L mol⁻¹ cm⁻¹, more preferably lower than 1000 L mol⁻¹ cm⁻¹, even more preferably lower than 500 L mol⁻¹ cm⁻¹, still more preferably lower than 200 L mol-1 cm-1, most preferably lower than 100 L mol⁻¹ cm⁻¹.

Preferably, the photoinitiator molecules may be converted into a reactive state due to the sequential absorption of light of the second wavelength which may trigger a polymerization in the local volume. In this regard, it may be provided that the light of the first wavelength is provided by two photons of the second wavelength, which are quasi-simultaneously absorbed. In other words, state A absorbs two photons of wavelength 2 and switches to B. B then absorbs another photon of wavelength 2 and forms C or starts polymerization.

Preferably, the photoinitiator molecules are converted into a reactive state due to the absorption of the light of the second wavelength, which may trigger a radical polymerization in the local volume.

Preferably, the light of the first wavelength is irradiated as a light beam and / or the light of the second wavelength is irradiated as a light beam. A light beam may have a diameter of 2 cm or less, preferably 1 cm or less, more preferably 0.5 cm or less, most preferably 1 mm or less. The light beam of the light of the first wavelength and the light beam of the light of the second wavelength may at least partially overlap in the local volume, preferably container, when irradiated.

Preferably, the light of the first wavelength is irradiated as a light sheet and the light of the second wavelength is irradiated as a projection of a 2D-image. The light sheet of the light of the first wavelength and the light projection of the light of the second wavelength may at least partially overlap in the local volume, preferably container, when irradiated.

Preferably, the light of the first wavelength is provided by at least two, preferably two, laser light sources, where the difference in wavelengths of the emission maxima of both light sources is below 10 nm, preferably, below 5 nm, more preferably below 1 nm, even more preferably below 0.5 nm, still more preferably below 0.2 nm, most preferably below 0.05 nm.

Typically, in photochemical reactions the exact wavelength of the irradiation source plays a minor role which is obvious from the fact that LEDs with their inherent broad emission bands are standard irradiation sources used in the state of the art. Surprisingly, for dual color photopolymerization a broad light source reduces the printing window, which is the intensity range of the first wavelength, where a dual color effect without hardening from the first wavelength alone is observed. Where the light of the first wavelength is provided from at least two light sources, the printing window and structure fidelity or quality of the printed object can be increased significantly by reducing the gap between the at least two emission maxima of the at least two light sources.

In one embodiment the first wavelength is in the range of 350 nm to 450 nm, preferably 360 nm to 410 nm.

In a preferred embodiment the second wavelength is in the range of 400 nm to 800 nm, more preferred in the range of 410 nm to 700 nm, even more preferred in the range of 420 nm to 600 nm, most preferred in the range of 430 nm to 550 nm.

In a preferred embodiment the second wavelength is in the range of 300 nm to 1000 nm, preferably 400 nm to 800 nm and has an emission maximum between 400 nm and 550 nm, preferably between 420 nm and 500 nm.

In another preferred embodiment the second wavelength is in the range of 300 nm to 1000 nm, preferably 400 nm to 800 nm and has the strongest emission maximum between 400 nm and 550 nm, preferably between 420 nm and 500 nm.

It has been found, that devices known from the state of the art show a poor dual color effect when photoinitiators according to formula (Ib) are used. Surprisingly, a significantly improved reactivity and/or dual color effect has been observed using a lower wavelength for the light of the second wavelength.

According to another aspect an apparatus for local polymerization of a starting material by means of dual color photopolymerization is created, wherein a filtering element is located between the local volume or container and the second light source.

Preferably, the filtering element may be characterized in that it reduces the intensity of the light of the second wavelength more at lower wavelengths than at higher wavelengths.

According to one embodiment, the filtering element may be less transparent at shorter wavelength than at longer wavelength in the range between 300 nm to 800 nm, preferably between 350 nm to 600 nm, more preferably between 370 nm and 500 nm, even more preferably between 390 nm and 490 nm most preferably between 410 nm and 450 nm.

Preferably, the filtering element may be a long-pass filter.

According to one embodiment, the filtering element may be an optical element, preferably a lens.

Surprisingly, it has been found that a filtering element, which is placed between the light source of the second wavelength and the container or local volume improves the dual color effect and/or the printing window. Even in formulations where the initiator shows almost no absorption at the second wavelength a significantly reduced object quality is observed, especially for prints extended in the direction of printing.

The aspect of an additional filtering element improves the object quality especially when dual color photoinitiators according to formula (Ib) are employed.

Preferably, the starting material is polymerized in several local volumes by means of photopolymerization and thus a three-dimensional shaped body is produced in the starting material.

A further aspect of the present invention is a process for 3D-printing a shaped body, wherein the shaped body is produced by means of a process as it is disclosed above.

To prevent migration and release of remaining photoinitiator molecule and/or their reaction products from the cured object the following measures are disclosed:
a) Substitution in a way, that the molecular weight exceeds 1000 g/mol
b) Binding of the photoinitiator molecule to a structure of higher molecular weight, such as an oligomer or a polymer
c) Functionalization of the photoinitiator molecule with polymerizable groups, which are build in the polymer network during curing, these include but are not limited to: acrylates, acrylamides, methacrylates, thiol + ene, epoxides, oxiranes, oxetanes, vinylethers.

The photoinitiator molecules are disclosed for curing any resin which contains molecules that bear a functional group which can be polymerized via a radical mechanism, these include but are not limited to derivatives of acrylate, methacrylate, acrylamide, thiol + ene, vinylacetate.

The disclosed photoinitiator molecules allow volumetric printing, both, due to their tunable thermal back reaction and their capability to initiate a polymerization only where light of both wavelengths interacts with the resin volume. The dual color initiators are not limited to a specific setup, but to give an illustrative example which shows the necessity of the thermal back reaction the following setup can be used: Volumetric printing can be conducted in a setup, which consists of a light sheet generator, a projector, a container that has four transparent sides and contains the resin including at least one of the disclosed photoinitiator molecule and a moveable stage to move either the container or the light sheet generator. Such a setup ensures a fast curing process over the whole volume, compared to the point by point setups described by Swainson [Swainson, US4041476, US4078229, US4238840, US4466080, US4471470, US4333165]. One layer of a volume is irradiated with electromagnetic radiation of a first wavelength to switch the photoinitiator molecule from A to B. An image is projected on that layer from a different direction, using electromagnetic radiation of the second wavelength, which induces a photopolymerization, where image and layer overlay. After a given amount of time, the electromagnetic radiation of the first wavelength is shifted to a neighboring layer and the next image is projected on this layer with electromagnetic radiation of the second wavelength. In the previous layer no further polymerization occurs due to the thermal back reaction to the A form, which causes a deactivation for electromagnetic radiation of the second wavelength. After a number of iteration steps, the 3-dimensional object is cured in the volume and can be taken out, or the residual resin can be washed away. The remaining object can be subjected to a post-processing.

In another aspect of the invention a sensitizer can be used to induce the switching from A to B. The sensitizer absorbs at a wavelength, where both forms A and B of the photoinitiator molecule show minimal or no absorption. When the sensitizer is excited by electromagnetic radiation of a first wavelength, energy transfer to the dual color initiator in form A occurs. The excited photoinitiator molecule form A then switches to the B form. B absorbs electromagnetic radiation of the second wavelength and initiates the polymerization via form C. The usage of a sensitizer is beneficial, where the absorbance at the first wavelength changes during the irradiation process, so that a homogenous switching and curing can be assured over the whole light path of the first wavelength. Furthermore, utilizing a sensitizer allows to apply higher concentrations of the photoinitiator molecule without increasing the absorbance at the first wavelength. A sensitizer can also allow for a larger object size, due to the more homogenous curing. Typical sensitizers known in the field can be used and include but are not limited to derivatives of
a) transition metal complexes such as trisbipyridine ruthenium complexes, zinc porphyrin complexes, iridium complexes, rhenium complexes, or platinum complexes;
b) boron dipyrromethene;
c) iodo or bromo substituted organic chromophores, such as Rose Bengal or Eosin B;
d) carbonyl compounds, such as naphthalene diimides, acetophenone, anthraquinone, thioxanthone, camphor quinone, benzophenone, diacetyl compounds, coumarin, benzylideneacetone, dibenzylideneacetone; and
e) polycyclic aromatic compounds, such as anthracene, pyrene, or fullerene.

Sensitizers according to d) and e) are particularly preferred.

Preferably, the co-initiator can be chosen from typical hydrogen donors or electron donors known in the field, which include but are not limited to derivatives of ethanolamine, aminobenzoic acid, germanes, thiols, alcohols, ethers, thioethers, silanes, phosphines, acetals, dialkylanilines, N-phenylglycine, arylsulfinates, iodonium salts, sulfonium salts, organoborate salts and mixtures of two or more thereof, preferably a combination of an iodonium salt and/or a sulfonium salt with at least one further co-initiator.

Where type 2 photoinitiator molecules are employed the co-initiator can be chosen from typical hydrogen donors or electron donors known in the field, which include but are not limited to derivatives of ethanolamine, aminobenzoic acid, germanes, thiols, alcohols, ethers, thioethers, silanes, phosphines, acetals, dialkylanilines, N-phenylglycine, arylsulfinates, iodonium salts, sulfonium salts, organoborate salts and mixtures of two or more thereof, preferably a combination of an iodonium salt and/or a sulfonium salt with at least one further co-initiator.

Alternatively, the co-initiator can be a derivative of ethanolamine, preferably a derivative of diethanolamine, more preferably an N-alkyldiethanolamin, alternatively N-methyldiethanolamin, N-phenyldiethanolamin, triethanolamine, 4-(2-hydroxyethyl)morpholine, *N*-(2-hydroxypropyl)morpholine, *N-tert-butyldiethanolamine, N-*butyldiethanolamine, *N*-(3-aminopropyl)diethanolamine, *N*,*N*-di(2-hydroxyethyl)glycine, 1-[bis(2-hydroxyethyl)amino]-2-propanol, *N*-phenyldiethanolamine, m-tolyldiethanolamine, *p-*tolyldiethanolamine, *N*-benzyldiethanolamine, bis(2-hydroxyethyl)aminotris(hydroxymethyl)methane, *N*,*N*-bis(2-hydroxypropyl)aniline, *N,N-*bis(2-hydroxyethyl)-2-aminoethanesulfonic Acid, *N*,*N*-bis(2-hydroxyethyl)-3-chloroaniline, *N*,*N*,*N'*,*N'*-tetrakis(2-hydroxyethyl)ethylenediamine, 3-[*N*,*N-*bis(2-hydroxyethyl)amino]-2-hydroxypropanesulfonic acid, *N*-lauryldiethanolamine, *N*,*N*,*N'*,*N'*-tetrakis(2-hydroxypropyl)ethylenediamine, *N*,*N*,*N'*,*N"*,*N*"-pentakis(2-hydroxypropyl)diethylenetriamine,

Alternatively, the co-initiator can be a derivative 4-aminobenzoic acid, preferably at least one of ethyl 4-(dimethylamino)benzoate (EDB), isoamyl 4-(dimethylamino)benzoate, 2-butoxyethyl 4-(dimethylamino)benzoate, 2-ethylhexyl 4-(dimethylamino)benzoate.

Dual color photoinitiators known from the state of the art are of low reactivity and therefore require derivatives of ethanolamine as co-initiators, which may cause substantial yellowing of the printed objects. Surprisingly, dual color photoinitiators according to formula (Ib) are of higher reactivity and therefore are not limited to derivatives of ethanolamine as co-initiators. As a solution to these problems resin formulations are disclosed, which comprise at least an acrylate monomer, a dual color photoinitiator of formula (Ib), and a derivative of 4-aminobenzoic acid, alternatively a derivative of 2-aminobenzoic acid.

Alternatively, the co-initiator can be an amine synergist or acrylated amine synergist, preferably an amine bound to a polymeric backbone, an amine bound to a multifunctional oligomer, or the reaction mixture from a multifunctional acrylate and an amine, more preferably the amine in the amine synergist is a derivative 4-aminobenzoic acid. Amine synergists according to the embodiment may be useful in applications which benefit from low migration of the co-initiator. Examples for such synergists include but are not limited to, Genopol AB-1, Genopol AB-2 (CAS 2067275-86-7), Esacure A198 (CAS 925246-00-0), Genopol RCX02-766, Omnipol ASA, Omnipol ASE, Speedcure 7040, Genomer 4514, Genomer 5161 (CAS 159034-91-0), Genomer 5275, CN550 (CAS 162492-04-8), CN3755 (CAS 67906-98-3), and Photomer 4775.

Preferably, the co-initiator is a combination of an iodonium salt with a derivative of 2-aminobenzoic acid and/or 4-amino benzoic acid and/or EDB.

It can be provided that a monomer comprised the formulations suitable for volumetric printing itself acts as a co-initiator, preferably said monomer is a thiol. Such an embodiment can be advantageous since no further co-initiator is needed.It can be provided that the formulation suitable for volumetric printing comprises a photoinitiator molecule of the formula (Ib) as defined herein, merocyanine and a type 1 photoinitiator. In such an embodiment, the merocyanine produced from the photoinitiator molecule due to the absorption of the light of the first wavelength may act as a sensitizer for activating the type 1 photoinitiator which then, in turn, creates radicals.

The co-initiator can be of high molecular weight, such as > 1000 g/mol, or bound to a polymer to prevent migration in the cured object. The co-initiator can contain polymerizable groups, such as acrylates or methacrylates which are built into the polymer network during curing to prevent later migration of the co-initiator. A typical example is the following:

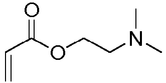

For the dual color volumetric printing approach, it is advantageous to control the viscosity of the resin. For type 2 initiators a high amount of co-initiator influences the viscosity of the resin. Therefore, it is beneficial in some cases to use co-initiators with a specific viscosity or mixtures of common co-initiators with low viscosity and highly viscous co-initiators. While co-initiators of low viscosity are commercially available, there is a lack for highly viscous co-initiators.

A highly viscous co-initiator is composed of a moiety which causes the high viscosity and a part which serves as a hydrogen donor. To achieve high viscosity one structural motif relies on a backbone, which is geometrically unable to build up enough intermolecular interactions to become solid. Due to the high molecular weight, the movement is restricted, which results in high viscosity. Another structural motif is based on multiple hydrogen bonds as in urethane containing mixtures. To ensure on the one hand well mixing with the monomer composition and on the other hand high reactivity the backbone of the co-initiator may be of a similar structure as the backbone which bears the monomer functionalities. Therefore, it can be beneficial to utilize a co-initiator which is based on a urethane structure together with a monomer composition that contains urethane moieties. It can be beneficial to utilize a co-initiator which is based on a bisphenol structure in combination with a monomer composition that also contains bisphenol moieties.

Suitable acids may be weak acids, such as acetic acid, formic acid, benzoic acid, or strong acids, such as trifluoroacetic acid.

Suitable bases may be amines, such as diisopropylethylamine, triethylamine, 1,8-diazabicyclo-[5.4.0]undec-7-ene (DBU), 1,5-diazabicyclo[4.3.0]non-5-ene (DBN), 1,5,7-triazabicyclo[4.4.0]dec-5-en (TBD), 2,6-di-*tert*-butylpyridine, and 1,4-diazabicycle[2.2.2]octan (DABCO).

Suitable solvents may be water or ethyl acetate. The formulation suitable for volumetric printing may be preferably free of solvent.

When typical acrylate resins are used for volumetric printing (xolography), the obtained objects may be brittle. Furthermore, oxygen inhibition reduces the reactivity of acrylate resins by quenching. Moreover, dual color photoinitiators known from the state of the art are of low reactivity and therefore require derivatives of ethanolamine as co-initiators, which may cause substantial yellowing of the printed objects. As a solution to these problems resin formulations are disclosed, which comprise at least a (meth)acrylate monomer, a dual color photoinitiator of formula (Ib), and a compound comprising a thiol moiety. Surprisingly, compounds of formula (Ib) show a dual color effect in the presence of thiols. It is known from the state of the art, that thiols may add to merocyanines, which may interfere with the dual color polymerization (Phys. Chem. Chem. Phys. 2014, 16, 12137), especially in presence of the basic amine co-initiator. Materials printed according to the disclosed formulations are of higher flexibility.

Typically, resins comprising thiol components suffer from dark reactions which leads to reduced shelf-life of the formulation, since the thiol content is reduced over time. The shelf-life stability may be improved by reducing the amount of acrylate or acrylamide monomers and employing resin formulations which contain methacrylate monomers. Particularly preferred are resins comprising less than 50% acrylate or acrylamide monomers, less than 25% acrylate or acrylamide monomers, less than 10% acrylate or acrylamide monomers, less than 5% acrylate or acrylamide monomers, less than 2% acrylate or acrylamide monomers.

Particularly preferred resin formulations are free of acrylate or acrylamide monomers.

In a preferred embodiment, the resin comprises methacrylate monomers. Even more preferred, the methacrylate monomer may contain at least 2 methacrylate moieties.

In another preferred embodiment the resin comprises a co-initiator, which is a derivative of ethanolamine or aminobenzoic acid.

In another preferred embodiment the resin comprises at least one iodonium or sulfonium salt.

In another preferred embodiment the resin may contain at least 50 % water.

In a further embodiment, it may be provided that at least one of the substituents R¹, R², R⁴ to R⁹, and R¹¹ to R³⁶ contains a functional group which increases the solubility in water. Such functional groups may be in particular ionic functional groups forming salts, such as ammonium, carboxylate, or sulfonate; polyethyleneglycols, or polar functional groups, such as OH, NH₂, SO₂NH₂.

In a preferred embodiment the thiol component may comprise at least 2 thiol moieties, even more preferred 3, most preferred at least 4.

In another preferred embodiment the thiol component may be of high viscosity at the printing temperature, preferably higher than 100 mPa s, more preferably higher than 500 mPa s, even more preferably higher than 2000 mPa s, still more preferred higher than 10000 mP s, most preferred higher than 100000 mPa s.

Particularly preferred thiol compounds are: 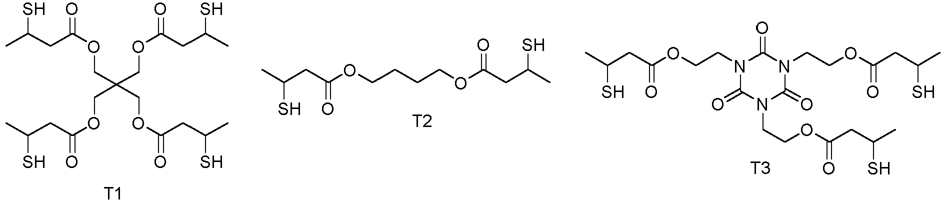 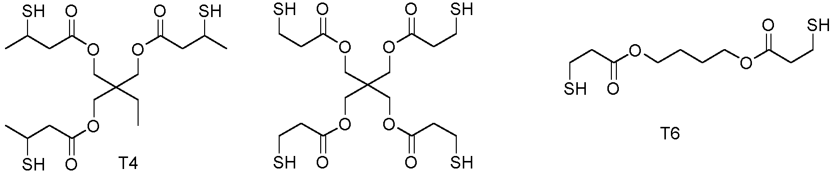 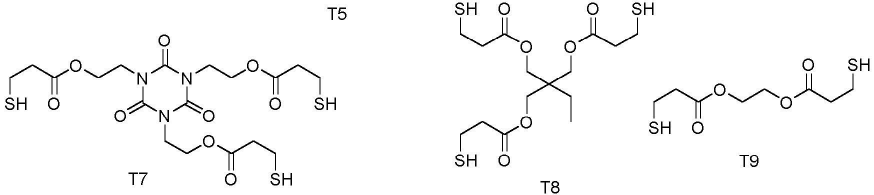 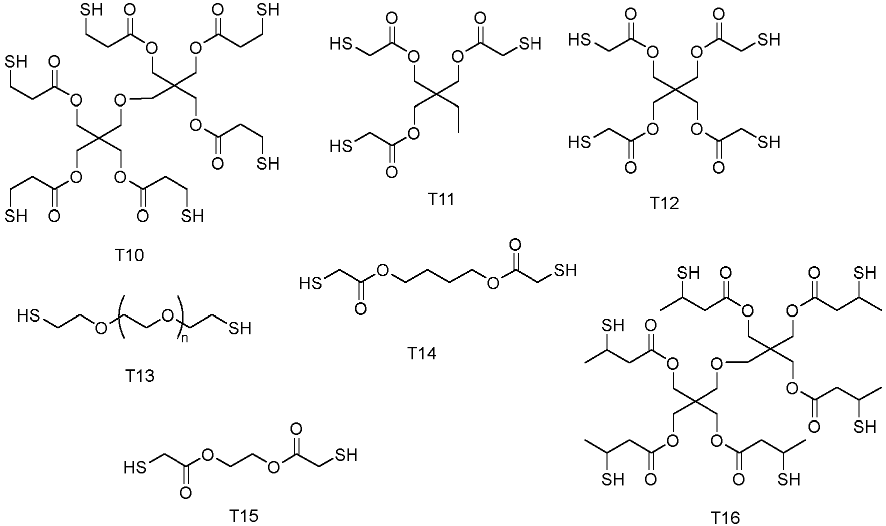
T1 Pentaerythritol tetrakis (3-mercaptobutylate)
T2 1,4-Bis (3-mercaptobutyroyloxy) butane
T3 1,3,5-Tris [2-(3-mercaptobutanoyloxy)ethyl]-i,3,5-triazine-2,4,6 (1H,3H,5H)-trione
T4 Trimethylol propane tris (3-mercaptobutylate)
T5 Pentaerythritol tetrakis-(3-mercapto-propionat)
T6 1,4-Butanediol bis(3-mercapto-propionat)
T7 Tris[2-(3-mercaptopropionyloxy)ethyl] isocyanurate
T8 Trimethylolpropane tri(3-mercapto propionate)
T9 Glycol di(3-mercaptopropionate)
T10 Dipentaerythritol hexakis(3-mercaptopropionate)
T11 Trimethylolpropane tris(thioglycolate)
T12 Pentaerythritol tetrakis(mercaptoacetate)
T13 PEG dithiol
T14 1,4-Butanediol bis(thioglycolate)
T15 Ethylene bis(thioglycolate)
T16 Dipentaerythritol hexakis(3-mercaptobutylate)

According to the invention, it may be intended that two or more of the above-mentioned embodiments are combined with each other.

Any combinations of embodiments, preferred ranges and/or moieties, in particular, preferred moities of the invention are particularly preferred.

### Brief description of drawings

In the following, further design examples are explained with reference to figures in a drawing, wherein
Fig. 1 shows a schematic representation of an embodiment of the process according to the invention;
Fig. 2 shows a schematic representation of the process according to the invention; and
Fig. 3 shows a perspective view of the embodiment of the inventive step shown in Fig. 2.
Fig. 4 shows UV/Vis spectra of the objects printed by using comparative compound C-1 and the compounds PM-1, PM-3, PM-4 and PM-5 according to the present disclosure.
Fig. 5 is a schematic view of a device for processing an optically reactive material from above.
Fig. 6 is a schematic view of the device of Fig. 5 from the side.

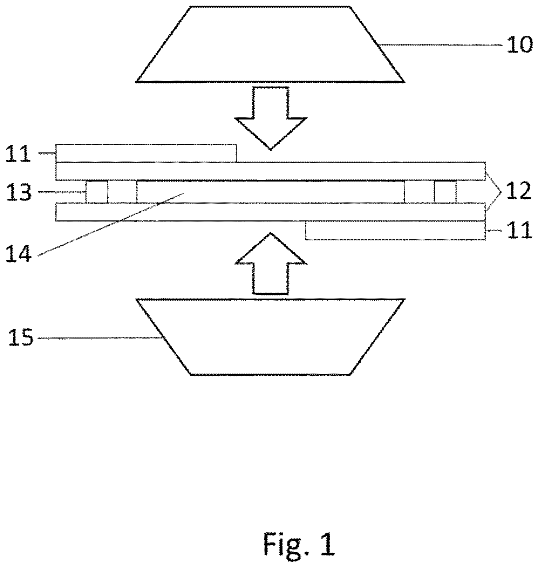

Figure 1 schematically shows an embodiment of the invention. By means of a first light source 10 a light with a first wavelength is generated and irradiated onto a structure comprising a curable composition 14. The assembly is a layered assembly comprising a light-blocking layer 11 and two transparent layers 12. The assembly further comprises a spacer 13. In the space formed by the two transparent layers 12 and the spacer 13, the curable composition 14 corresponding to the polymerizable starting material and containing one or more photoinitiator molecules according to the invention is introduced. The layered structure further comprises two light-blocking layers 11 arranged so that at least a portion of the curable composition 14 can be irradiated by both the light of the first wavelength generated by the first light source 10 and a light of a second wavelength generated by the second light source 15. The region of the curable composition 14 which can be irradiated both by light from the first light source 10 and by light from the second light source 15 is cured according to the mechanism described herein.

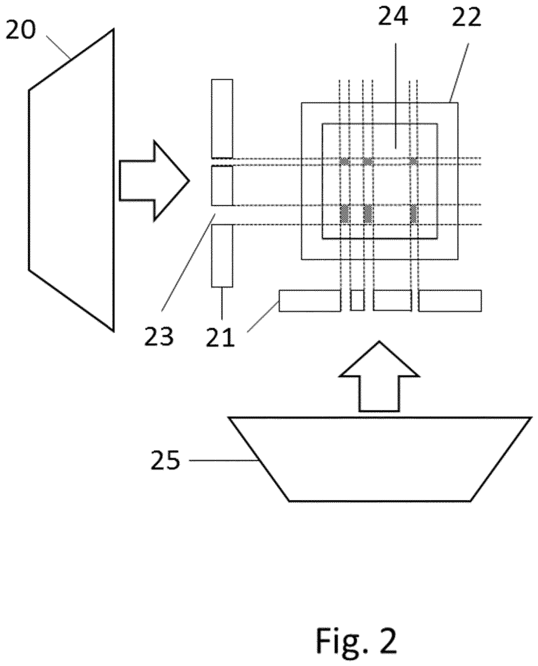

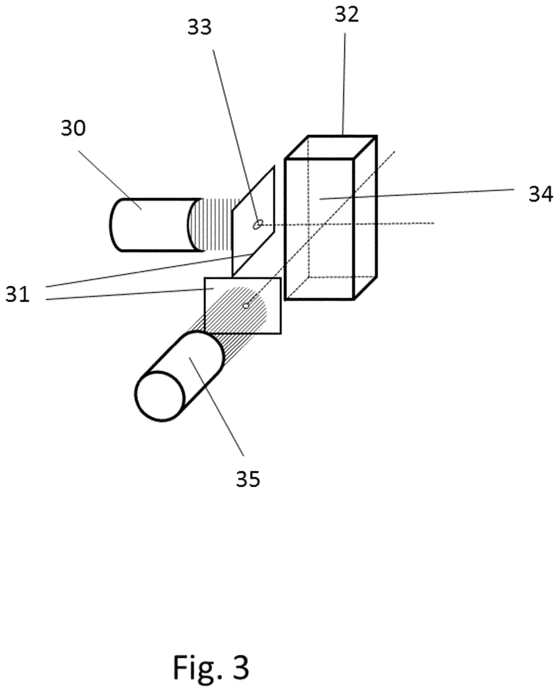

Figures 2 and 3 show a further embodiment of the invention in which a part of a curable composition 24, 34, is cured, which is simultaneously irradiated both by light from a first light source 20, 30 and light from a second light source 25, 35 through holes 23, 33 in light-blocking layers 21, 31 which partially shield the curable composition 24, 34 from the respective light sources 20, 30 and 25, 35, respectively. The curable composition 24, 34 is here arranged in a transparent container 22, 32. In this version it is provided that the light source 20, 30 is arranged orthogonally with respect to the second light source 25, 35. In principle, however, other angles are also provided here according to the invention.

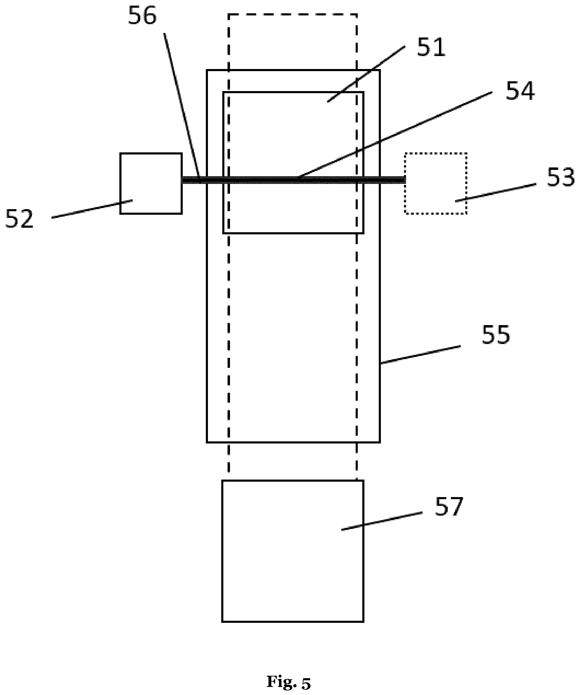

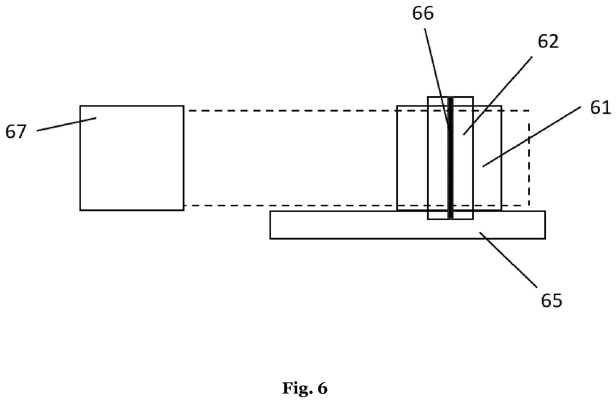

Figs. 5 and 6 show a schematic representation of an arrangement for a device for optical processing of an optically reactive material from above and from the side. A working volume is provided in a receiving container 51, 61, which is at least partially filled by a starting material. The starting material can comprise one or more substances, which can be solid, liquid or pasty. For processing, the starting material is irradiated with light of a first wavelength from a first light generator 52, 62 and optionally light of a first wavelength from a second light generator 53, which are irradiated in an overlapping manner in the working volume to trigger an optically activated reaction in a layer subvolume 54. The receiving container 51, 61, which is at least partially filled by a starting material may be moved along an axis for cuvette moving 55, 65 to shift the position of the subvolume 54 in the receiving container 51, 61 and in the starting material filled therein.

Alternatively, the first light generator 52, 62 and optionally the second light generator 53 may be moved along an axis to shift the position of the subvolume 54 in the receiving container 51, 61 and in the starting material filled therein (not shown in Figs. 5 and 6).

The first light generator 52, 62 and optionally the second light generator 53 may be a light sheet generator.

Depending on the current position of the irradiation area 56, 66 (light sheet), the light of the second wavelength is projected with the aid of a projector 57, 67 into the layered part volume currently irradiated with the light of the first wavelength (projector or projection image). This means that the projection plane or projection volume of the projector 57, 67 is located in the layer subvolume that is currently being irradiated with the light of the first wavelength. The light of the first wavelength (light section) and the light of the second wavelength (light projection) thus at least partially overlap spatially or in a projection plane of the projector 57, 67 in a macroscopic partial layer volume of the starting material, which as a partial volume of the working volume which is just being irradiated by means of the light section.

In this way, at least one material property of the starting material is changed in the currently irradiated layered partial volume, for example to the effect that the original starting material hardens. In this case, polymerization can be triggered in the starting material due to the coincidence of the light of the two wavelengths. In this way, it is possible, for example, to continuously produce a three-dimensionally shaped body layer by layer in the working volume. The three-dimensional shaping of the body is influenced and determined with the aid of the projection of the projector 57, 67 formed in the respective layer volume.

In one embodiment, a process for local polymerization of a polymerizable starting material by means of dual color polymerization is provided. In dual color polymerization, photoinitiator molecules, which can also be designated as mediator molecules, absorb photons of light of different wavelengths in order to convert the photoinitiator molecules from the initial state via an intermediate state into a reactive state which is suitable for locally initiating or initiating a polymerization reaction in the polymerizable starting material so that the starting material is polymerized, up to hardening or curing, in particular in the case of plastics.

The mediator molecule, in the following also called photoinitiator molecule, and its necessary function can be produced in different ways. One example provides the following:

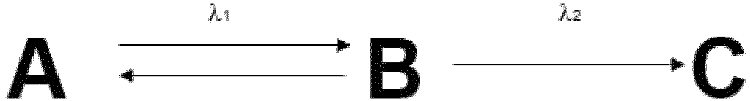

The photoinitiator can exist in three different states, which are characterized as follows:
Initial state (A):
   - Without light irradiation the photoinitiator molecules are present in this state.
Intermediate state (B):
   - The B state is an electronic ground state.
   - The intermediate state is created from the initial state A by absorption of light of wavelength λ₁.
   - The photoinitiator molecules have a new or more intense absorption band for light of wavelength λ₂.
   - Alternatively, the absorption band for □1 disappears. The photoinitiator molecule returns to the initial state A spontaneously in the absence of light or by absorption of light of wavelength λ₃.
Reactive state (C):
   - The reactive state is generated from the intermediate state B by absorption of light of wavelength λ₂.
   - The reactive state initiates a polymerization reaction in the immediate vicinity of the molecule.
   - A back reaction to B is not intended.

### EXAMPLES

Hereinafter, the action and effect of the invention will be described in detail through specific examples of the invention. However, the examples are provided only to illustrate the present invention, and the scope of the invention is not limited thereto.

### Synthesis

### Synthesis of compound PM-1

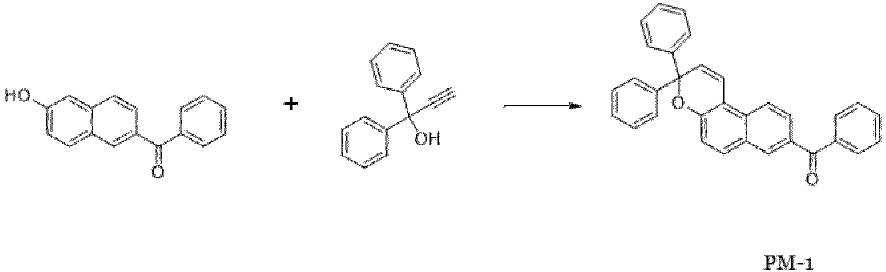

1,1-Diphenyl-2-propyn-1-ol (1 g, 4.8 mmol) and 6-Benzoyl-2-naphthol (1.2 g, 4.8 mmol) are suspended in toluene (15 mL) and heated to 60 °C. p-Toluenesulfonic acid (14 mg, 0.07 mmol) is added, and the mixture is stirred at 60 °C for 2h. After cooling to room temperature ethyl acetate is added and the organic phase is washed with aqueous sodium hydroxide solution (1 M), water, and saturated aqueous sodium chloride solution. The remaining organic phase is dried over anhydrous magnesium sulfate and the solvents are removed under reduced pressure. The crude product is purified by silica gel column chromatography using petroleum ether / ethyl acetate (9/1) as eluent to yield compound PM-1 as a solid (1.57g, 90%).

¹H NMR (500 MHz, Methylene Chloride-*d*₂) δ 8.16 (d, *J* = 1.8 Hz, 1H), 8.08 (d, *J* = 8.8 Hz, 1H), 7.95 (dd, *J* = 8.8,1.8 Hz, 1H), 7.84 - 7.79 (m, 2H), 7.77 (d, *J* = 8.8 Hz, 1H), 7.65 - 7.60 (m, 1H), 7.55 - 7.49 (m, 6H), 7.41 - 7.32 (m, 5H), 7.31 - 7.26 (m, 3H), 6.39 (d, *J* = 10.0 Hz, 1H).

### PM-2

### PM-2 (CAS 4222-20-2) is commercially available

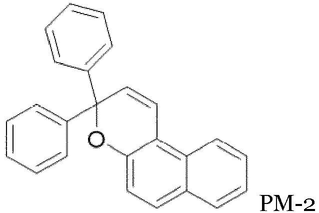

### Synthesis of compound PM-3

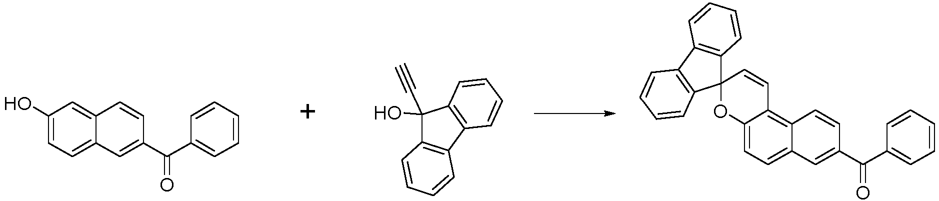

9-Ethynyl-9H-fluoren-9-ol (415 mg, 2.0 mmol) and 6-Benzoyl-2-naphthol (0.5 g, 2.0 mmol) are suspended in toluene (10 mL) and heated to 60 °C. *p*-Toluenesulfonic acid (6 mg, 0.03 mmol) is added, and the mixture is stirred at 60 °C for 2h. After cooling to room temperature ethyl acetate is added and the organic phase is washed with aqueous sodium hydroxide solution (1 M), water, and saturated aqueous sodium chloride solution. The remaining organic phase is dried over anhydrous magnesium sulfate and the solvents are removed under reduced pressure. The crude product is purified by silica gel column chromatography using petroleum ether / ethyl acetate mixtures as eluent to yield compound PM-3 as a solid (1.57g, 90%).

¹H NMR (500 MHz, Methylene Chloride-*d*₂) δ 8.26 - 8.18 (m, 2H), 8.02 (dd, *J* = 8.8, 1.8 Hz, 1H), 7.88 - 7.84 (m, 2H), 7.77 (d, *J* = 8.8 Hz, 1H), 7.71 (dt, *J* = 7.6, 0.9 Hz, 2H), 7.64 (ddt, *J* = 8.0, 6.9, 1.3 Hz, 1H), 7.57 - 7.50 (m, 5H), 7.45 (td, *J* = 7.5, 1.1 Hz, 2H), 7.27 (td, *J* = 7.5, 1.1 Hz, 2H), 7.08 (dd, *J* = 8.8, 0.7 Hz, 1H), 5.77 (d, *J* = 10.1 Hz, 1H).

### Synthesis of PM-4

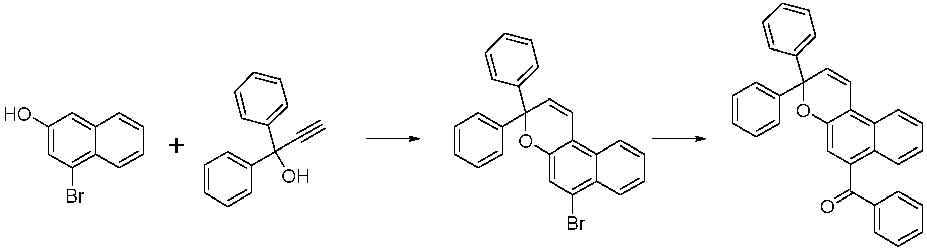

1,1-Diphenyl-2-propyn-1-ol (0.93 g, 4.5 mmol) and 4-Bromo-2-naphthol (1 g, 4.5 mmol) are suspended in toluene (20 mL) and heated to 55 °C. *p*-Toluenesulfonic acid (13 mg, 0.067 mmol) is added, and the mixture is stirred at 55 °C for 2h. After cooling to room temperature ethyl acetate is added and the organic phase is washed with aqueous sodium hydroxide solution (1 M), water, and saturated aqueous sodium chloride solution. The remaining organic phase is dried over anhydrous magnesium sulfate and the solvents are removed under reduced pressure. The crude product is purified by silica gel column chromatography using petroleum ether / ethyl acetate (9/1) as eluent to yield the halogenated naphthopyran as a white solid (1.36 g, 73%).

¹H NMR (500 MHz, Chloroform-d) δ 8.19 - 8.12 (m, 1H), 8.02 - 7.95 (m, 1H), 7.59 (d, *J =* 0.7 Hz, 1H), 7.53 (ddd, *J* = 8.4, 6.8, 1.3 Hz, 1H), 7.51 - 7.47 (m, 4H), 7.44 (ddd, *J* = 8.2, 6.8, 1.2 Hz, 1H), 7.38 - 7.31 (m, 4H), 7.31 - 7.27 (m, 3H), 6.31 (d, *J* = 10.0 Hz, 1H).

The halogenated naphthopyran (0.5 g, 1.2 mmol) is dissolved in dry tetrahydrofuran (8 mL) under an argon atmosphere and cooled to -78°C. *n*-Butyl lithium (1.3 mmol, 2.5 M in hexanes) is added dropwise. After stirring for 30 min at -78°C, N-Methoxy-N-methylbenzamide (0.2 g, 1.3 mmol) is added, and the reaction mixture is allowed to warm to room temperature. The reaction is stirred for 3h at room temperature and 1 M aqueous hydrochloric (10 mL) acid is added. The mixture is stirred for 20 min, 1 M aqueous NaOH solution is added (20 mL) and the mixture is extracted with ethyl acetate. The combined organic layers are dried over anhydrous MgSO₄ and evaporated under reduced pressure. The residue is purified by silica-gel column chromatography using petroleum ether / ethyl acetate (9/1) as eluent to yield the compound PM-4 as a solid (0.39 g, 73%).

¹H NMR (500 MHz, Chloroform-d) δ 7.94 (dt, *J* = 8.6, 0.9 Hz, 1H), 7.87 (dt, *J* = 8.5, 0.9 Hz, 1H), 7.78 - 7.71 (m, 2H), 7.49 (ddt, *J =* 8.7, 7.2, 1.3 Hz, 1H), 7.40 (ddd, *J =* 8.4, 6.8, 1.3 Hz, 1H), 7.38 - 7.32 (m, 6H), 7.30 - 7.26 (m, 1H), 7.25 - 7.19 (m, 6H), 7.18 - 7.14 (m, 2H), 6.30 (d, *J* = 10.0 Hz, 1H).

### Synthesis of PM-5

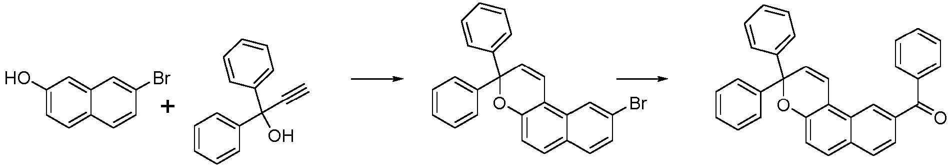

1,1-Diphenyl-2-propyn-1-ol (1.2 g, 5.8 mmol) and 4-Bromo-2-naphthol (1.3 g, 5.8 mmol) are suspended in toluene (20 mL) and heated to 55 °C. p-Toluenesulfonic acid (16 mg, 0.09 mmol) is added, and the mixture is stirred at 55 °C for 1h. After cooling to room temperature ethyl acetate is added and the organic phase is washed with aqueous sodium hydroxide solution (1 M), water, and saturated aqueous sodium chloride solution. The remaining organic phase is dried over anhydrous magnesium sulfate and the solvents are removed under reduced pressure. The crude product is purified by silica gel column chromatography using petroleum ether / ethyl acetate (9/1) as eluent to yield the halogenated naphthopyran as a white solid (2.2 g, 92%).

¹H NMR (500 MHz, Chloroform-d) δ 8.10 (d, *J* = 1.8 Hz, 1H), 7.61 (d, *J* = 8.8 Hz, 1H), 7.56 (d, *J* = 8.7 Hz, 1H), 7.49 (t, *J* = 1.8 Hz, 2H), 7.48 (dd, *J* = 1.9, 0.8 Hz, 2H), 7.38 (dd, *J* = 8.7, 1.9 Hz, 1H), 7.35 - 7.31 (m, 4H), 7.29 - 7.25 (m, 2H), 7.24 - 7.19 (m, 2H), 6.29 (d, *J* = 10.0 Hz, 1H).

The halogenated naphthopyran (1.1 g, 2.7 mmol) is dissolved in dry tetrahydrofuran (20 mL) under an argon atmosphere and cooled to -78°C. n-Butyl lithium (2.9 mmol, 2.5 M in hexanes) is added dropwise. After stirring for 30 min at -78°C, N-Methoxy-N-methylbenzamide (0.44 g, 2.9 mmol) is added and the mixture is stirred for 30 min at -78°C. The reaction mixture is allowed to warm to room temperature. The reaction is stirred for 1h at room temperature and 1 M aqueous hydrochloric (10 mL) acid is added. The mixture is stirred for 20 min, 1M aqueous NaOH solution is added (20 mL) and the mixture is extracted with ethyl acetate. The combined organic layers are dried over anhydrous MgSO₄ and evaporated under reduced pressure. The residue is purified by silica-gel column chromatography using petroleum ether / ethyl acetate (9/1) as eluent to yield the compound PM-5 as a solid (0.73 g, 63%).

¹H NMR (500 MHz, Chloroform-d) δ 8.44 - 8.40 (m, 1H), 7.88 - 7.83 (m, 2H), 7.80 (d, *J* = 8.4 Hz, 1H), 7.72 (dd, *J* = 8.5, 1.7 Hz, 2H), 7.65 - 7.6o (m, 1H), 7.52 (dd, *J* = 8.3, 7.0 Hz, 2H), 7.49 - 7.46 (m, 4H), 7.35 - 7.30 (m, 5H), 7.26 (ddt, *J* = 7.2, 6.2,1.3 Hz, 3H), 6.29 (d, *J* = 10.0 Hz, 1H).

### Synthesis of PM-6

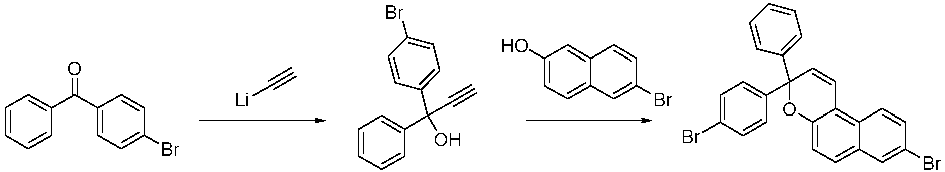

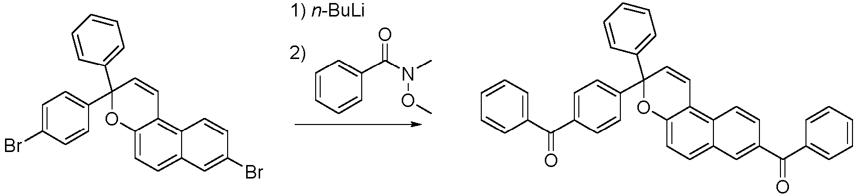

4-Bromobenzen (10.0 g, 38.5 mmol) is dissolved in dry tetrahydrofuran (100 mL) and cooled to 0 °C. Lithium acetylide ethylenediamine complex (20.8 g 192.5 mmol) is added and the mixture is stirred for 3 days. 1 M aqueous hydrochloric (150 mL) acid is added and the mixture is extracted with ethyl acetate. The combined organic layers are dried over anhydrous MgSO₄ and evaporated under reduced pressure. The residue is purified by silica-gel column chromatography using petroleum ether / ethyl acetate (20/1) as eluent to yield 1-(p-Bromophenyl)-1-phenyl-2-propyn-1-ol (7.1 g, 60%).

¹H NMR (500 MHz, Chloroform-d) δ 7.61 - 7.57 (m, 2H), 7.50 - 7.44 (m, 4H), 7.37 - 7.32 (m, 2H), 7.32 - 7.27 (m, 1H), 2.94 (s, 1H), 2.89 (s, 1H).

1-(p-Bromophenyl)-1-phenyl-2-propyn-1-ol (1.9 g, 6.6 mmol), 6-Bromo-2-naphthol (1.5 g, 6.6 mmol), and *p*-Toluenesulfonic acid (94 mg, 0.5 mmol) are suspended in chloroform (300 mL), and the mixture is stirred at room temperature for 18h. The crude product precipitates, is filtered, and washed with aqueous sodium hydroxide solution (1 M) and water. The crude product is purified crystallization from ethyl acetate to yield the dibromo naphthopyran as a white solid (2.5 g, 77%).

¹H NMR (500 MHz, Chloroform-d) δ 7.86 (d, *J =* 2.0 Hz, 1H), 7.80 (d, *J* = 9.1 Hz, 1H), 7.56 (d, *J* = 8.9 Hz, 1H), 7.52 (dd, *J* = 9.0, 2.1 Hz, 1H), 7.51 - 7.42 (m, 4H), 7.38 - 7.31 (m, 4H), 7.31 - 7.27 (m, 1H), 7.27 - 7.23 (m, 1H), 7.19 (dd, *J* = 8.9, 0.7 Hz, 1H), 6.22 (d, *J* = 9.9 Hz, 1H).

The dibromo naphthopyran (1.0 g, 2.0 mmol) is dissolved in dry tetrahydrofuran (20 mL) under an argon atmosphere and cooled to -78°C. n-Butyl lithium (4.5 mmol, 2.5 M in hexanes) is added dropwise. After stirring for 30 min at -78°C, N-Methoxy-N-methylbenzamide (0.68 g, 4.5 mmol) is added and the mixture is stirred for 30 min at -78°C. The reaction mixture is allowed to warm to room temperature. The reaction is stirred for 2 h at room temperature and 1 M aqueous hydrochloric (20 mL) acid is added. The mixture is stirred for 20 min, 1 M aqueous NaOH solution is added (40 mL) and the mixture is extracted with ethyl acetate. The combined organic layers are dried over anhydrous MgSO₄ and evaporated under reduced pressure. The residue is purified by silica-gel column chromatography using petroleum ether / ethyl acetate (9/1) as eluent to yield the compound PM-6 as a solid (0.52 g, 47%).

¹H NMR (500 MHz, Chloroform-d) δ 8.17 (d, *J* = 1.8 Hz, 1H), 8.06 (d, *J* = 8.8 Hz, 1H), 7.97 (dd, J = 8.8, 1.8 Hz, 1H), 7.84 - 7.81 (m, 2H), 7.81 - 7.72 (m, 5H), 7.64 - 7.60 (m, 3H), 7.60 - 7.55 (m, 1H), 7.53 - 7.48 (m, 4H), 7.48 - 7.44 (m, 2H), 7.42 - 7.34 (m, 3H), 7.33 - 7.27 (m, 2H), 6.34 (d, *J* = 10.0 Hz, 1H).

### Synthesis of comparative compound C1

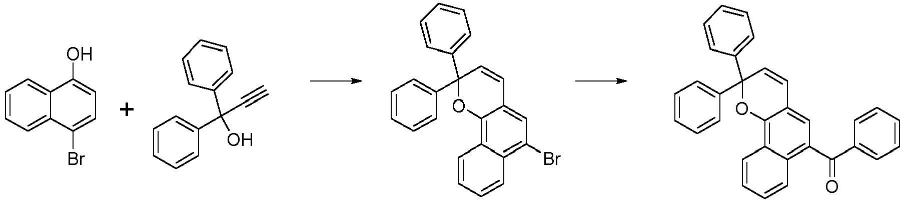

1,1-Diphenyl-2-propyn-1-ol (1.7 g, 8.2 mmol) and 4-Bromo-2-naphthol (1 g, 4.5 mmol) are suspended in toluene (20 mL) and heated to 60 °C. p-Toluenesulfonic acid (13 mg, 0.07 mmol) is added, and the mixture is stirred at 60 °C for 2h. After cooling to room temperature ethyl acetate is added and the organic phase is washed with aqueous sodium hydroxide solution (1 M), water, and saturated aqueous sodium chloride solution. The remaining organic phase is dried over anhydrous magnesium sulfate and the solvents are removed under reduced pressure. The crude product is purified by silica gel column chromatography using petroleum ether / ethyl acetate (9/1) as eluent to yield the halogenated naphthopyran as a white solid (0.77 g, 40%). The halogenated naphthopyran (0.77 g, 1.9 mmol) is dissolved in dry tetrahydrofuran (10 mL) under an argon atmosphere and cooled to -78°C. n-Butyl lithium (2.0 mmol, 2.5 M in hexanes) is added dropwise. After stirring for 45 min at -78°C, N-Methoxy-N-methylbenzamide (0.44 g, 2.9 mmol) is added and the mixture is stirred for 30 min at -78°C. The reaction mixture is allowed to warm to room temperature. The reaction is stirred for 3h at room temperature and 1 M aqueous hydrochloric (10 mL) acid is added. The mixture is stirred for 20 min, 1 M aqueous NaOH solution is added (20 mL) and the mixture is extracted with ethyl acetate. The combined organic layers are dried over anhydrous MgSO₄ and evaporated under reduced pressure. The residue is purified by silica-gel column chromatography using petroleum ether / ethyl acetate (10/1) as eluent to yield the compound C-1 as a solid (0.4 g, 49%).

¹H NMR (500 MHz, Chloroform-d) δ 8.49 - 8.41 (m, 1H), 8.26 (dd, *J* = 8.0, 1.5 Hz, 1H), 7.88 - 7.80 (m, 2H), 7.61 - 7.56 (m, 1H), 7.56 - 7.48 (m, 6H), 7.45 (t, *J* = 7.7 Hz, 2H), 7.38 - 7.32 (m, 5H), 7.32 - 7.26 (m, 2H), 6.67 (d, *J* = 9.8 Hz, 1H), 6.23 (d, *J* = 9.7 Hz, 1H).

### C-2

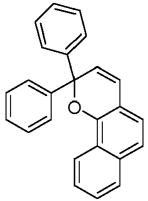

The synthesis of comparative compound C-2 is disclosed in Pozzo et al. Helvetica Chimica Acta, 1997, 80, 3, 725 - 738.

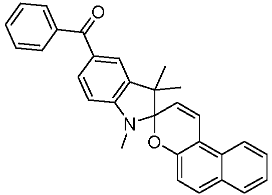

The synthesis of comparative compound C-3 is disclosed in WO 2020/245456 A1.

The following Table 1 shows the reactivity of the respective formulations 1-9 under simultaneous irradiation with 375 nm (Formulations 1-3, 5-8: 4.5 mW/cm²; Formulations 4,9: 12.5 mW/cm²) and 455 nm (26.8 mW/cm²) in an experiment according to Figure 1. The table gives the time until curing or solidification or a phase transition in the volumes which are irradiated with both wavelengths is observed. After the given time a similar curing or solidification or phase transition is not observed in the volumes which are irradiated with only one wavelength. Typically, an object is formed on at least one of the transparent layers according to Figure 1. The object can be washed with solvent and further analyzed or isolated. Homogeneous irradiation was performed using LEDs M455L2 and M375L4 each in combination with an adjustable collimation adapter SM2F32-A, all available from Thorlabs inc. The intensity has been measured with a power meter consisting of PM400 and PM16-130, available from Thorlabs inc. The thickness of the volume has been adjusted to 0.65 mm.

**Table 1: Comparative Formulations for different dual color photoinitiators**

| No. | DCPI | DCM | TEOA | PETA | ACMO | MDEA | UDMA | Reaction time |
|---|---|---|---|---|---|---|---|---|
| 1 | C1 12 mg | 1 mL | 300 mg | 1 g | | | | >10 min |
| 2 | PM-4 12 mg | 1 mL | 300 mg | 1 g | | | | 3 min |
| 3 | PM-1 16.3 mg | | | | 1.4 g | 1 g | 20.4 g | 1.5 min |
| 4 | PM-2 8.2 mg | | | | 1.4 g | 1 g | 20.4 g | 12 min |
| 5 | PM-3 8.4 mg | | | | 0.7 g | 0.5 g | 10.2 g | 40 s |
| 6 | PM-4 16.3 mg | | | | 1.4 g | 1 g | 21.4 g | 40 s |
| 7 | PM-5 16.5 mg | | | | 1.4 g | 1 g | 20.2 g | 30 s |
| 8 | C-1 16.3 mg | | | | 1.4 g | 1 g | 21.4 g | 5.5 min |
| 9 | C-2 7.9 mg | | | | 0.7 g | 0.5 g | 10.2 g | 15 min |

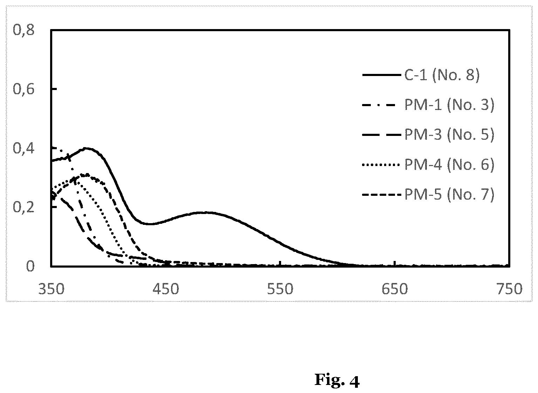

Comparing the reactivity of different naphthopyrans in the same formulation surprisingly reveals that [2,1-b]naphthopyran is a more reactive dual color photoinitiator than [1,2-b]naphthopyran (No. 4 and 9). Furthermore, the introduction of carbonyl substituents results in an increased reactivity (No. 4 and 7). Also for carbonyl substituted derivatives the reactivity of [2,1-b]naphthopyran derivatives is surprisingly higher than the reactivity of the respective [1,2-b]naphthopyran (No. 1 and 2; No. 6 and 8). The higher reactivity for carbonyl substituted [2,1-b]naphthopyran derivatives is independent of the positioning of the carbonyl group (No. 3, 6, and 7). The two aryl substituents on the [2,1-b]naphthopyran are not limited to unsubstituted phenyl substituents (No. 5). Surprisingly cured resins from formulations containing [2,1-b]naphthopyrans showed little or no coloring directly after polymerization without further post treatment of the printed object. Specifically, the absorption of printed objects between 450 nm and 800 nm was found to be neglectable. For some [2,1-b]naphthopyrans no absorption in the cured objects has been observed in the region between 400 nm and 1000 nm. The objects also remain colorless or little colored when stored under ambient light conditions. The cured resin of formulation No. 8 is colored, similar to objects described in the state of the art (European Polymer Journal, 2023, 196, 112312 and Nature, 2020, 588, 620). Figure 4 shows absorption spectra of the comparative objects which have been obtained using the conditions given in Table 1.

While the documents cited in the state of the art concentrate on acrylate based resins in dual color volumetric printing, it may be advantageous to include thiol based monomers or oligomers in a formulation. Thiol based monomers such as Trimethylolpropane tris(3-mercaptopropionate) (TMPMP) or Pentaerythritol tetrakis(3-mercaptopropionate) (PETMP) may lead to a more controlled polymerization yielding less brittle materials. Furthermore, oxygen inhibition is a common problem in polymerization techniques which rely on low concentrations of photoinitiators such as dual color volumetric printing. Thiols may be helpful to decrease the oxygen inhibition and can act as chain-transfer agents. Additionally, thiols can act as co-initiators and may be used to substitute the otherwise employed amine co-initiator resulting in formulations with reduced or no amine content. A low amine content is especially relevant for non or low yellowing materials. Therefore, there is a need for dual color photoinitiators which are compatible and reactive with thiols. No such dual color photoinitiator is known from the state of the art.

The following Table 2 shows the reactivity of the respective formulations 10-13 under simultaneous irradiation with 375 nm (4.5 mW/cm2) and 455 nm (26.8 mW/cm2) in an experiment according to Figure 1. The table gives the time until curing or solidification or a phase transition in the volumes which are irradiated with both wavelength is observed. After the given time a similar curing or solidification or phase transition is not observed in the volumes which are irradiated with only one wavelength. Homogeneous irradiation was performed using LEDs M455L2 and M375L4 each in combination with an adjustable collimation adapter SM2F32-A, all available from Thorlabs inc. The intensity has been measured with a power meter consisting of PM400 and PM16-130, available from Thorlabs inc. The thickness of the volume has been adjusted to 0.65 mm.

**Table 2: Reactivity of formulations containing the thiol-based monomer TMPMP and dual color photoinitiators**

| No. | PM-5 | ACMO | Co-Initiator | UDMA | TMPMP | Reaction time |
|---|---|---|---|---|---|---|
| 10 | 8.2 mg | 0.7 g | MDEA 0.5 g | 10.0 g | 0.5 g | 30 s |
| 11 | 8.4 mg | 0.7 g | MDEA 0.5 g | 9.2 g | 1.0 g | 30 s |
| 12 | 8.0 mg | 0.7 g | - | 9.7 g | 1.0 g | 3 min |
| 13 | 12.4 mg | 0.7 g | - | 10.6 g | 6.3 g | 2.5 min |

Naphthopyran based dual color photoinitiators show high reactivity and a dual color effect in formulations containing thiol-based monomers. The reactivity of formulations with and without thiol are similar (No. 7, 10, 11). Furthermore, in presence of a thiol an amine-based co-initiator is not necessarily required (No. 12). Naphthopyran based dual color photoinitiators may also be suitable for resins, where the number of thiol moieties and the number of ene moieties are similar or equal (No. 13). Formulations containing thiols form more homogenous networks due to an at least partial step-growth mechanism in contrast to a pure free radical polymerization. This results in more flexible and less brittle materials. A further advantage lies in the reduced oxygen inhibition, which is of high importance as in volumetric printing approaches the exclusion of oxygen from highly viscous resins is difficult. It is known from the state of the art, that spiropyrans react with thiols in a dark reaction, which may interfere with the dual color polymerization (Phys. Chem. Chem. Phys. 2014, 16, 12137) and may render them not suited for conducting thiol-ene polymerizations. Surprisingly, the employed naphthopyran-based dual color photoinitiators do not seem to suffer from such a reaction and can be utilized when thiols are present in the formulation.

According to the documents cited in the state of the art, the typically employed co-initiator is a derivative of ethanolamine, usually N-Methyldiethanolamine or Triethanolamine. Ethanolamine derivates are highly reactive co-initiators but suffer from low long-term stability and yellowing of the cured material. Furthermore, such co-initiators are of low molecular weight, allowing for migration and leakage of residual co-initiators from the cured object. To prevent leakage and migration oligomer-bound co-initiators on the basis of aminobenzoic acid derivatives have been invented. Therefore, there is a need for dual color photoinitiators which are compatible and reactive with derivatives of aminobenzoic acid or other co-initiators of lower reactivity. No such dual color photoinitiator is known from the state of the art.

The following Table 3 shows the reactivity of the respective formulations 14-17 under simultaneous irradiation with 375 nm (Formulations 15-17: 4.5 mW/cm2) or 405 nm (Formulation 15: 18 mW/cm2) and 455 nm (26.8 mW/cm2) in an experiment according to Figure 1. The table gives the time until curing or solidification or a phase transition in the volumes which are irradiated with both wavelength is observed. After the given time a similar curing or solidification or phase transition is not observed in the volumes which are irradiated with only one wavelength. Homogeneous irradiation was performed using LEDs M455L2 and M375L4 each in combination with an adjustable collimation adapter SM2F32-A, all available from Thorlabs inc. The intensity has been measured with a power meter consisting of PM400 and PM16-130, available from Thorlabs inc. The thickness of the volume has been adjusted to 0.65 mm.

**Table 3: Example formulations with co-initiators and additives**

| No. | PM-5 | ACMO | co-initiator | UDMA | Additive | Reaction time |
|---|---|---|---|---|---|---|
| 14 | 26.9 mg | 0.35 g | - | 5.0 g | I907 49 mg | 9 min |
| 15 | 8.2 mg | 0.7 g | EHDBA 500 mg | 10.7 g | | 6min |
| 16 | 8.2 mg | 0.7 g | EHDBA 500 mg | 10.7 g | DPI 50 mg | 2min |
| 17 | 4.7 mg | 0,35 g | - | 5.0 g | DPI 56 mg | 6 min |

Naphthopyran based dual color photoinitiators show reactivity and a dual color effect in formulations containing the type1 initiator I907 instead of a co-initiator (No. 14). Surprisingly also the EHDBA co-initiator which is not based on ethanolamine has been found to be reactive. Even more surprisingly a synergistic effect has been found, when the EHDBA co-initiator is combined with an iodonium salt (No, 15, 16, 17) resulting in an increased reactivity.

For the evaluation of the performance of a dual color photoinitiator in volumetric printing a respective volumetric printing experiment has been conducted. The typically applied wavelength 405 nm has been chosen as the first wavelength supplied from a laser source, while the second wavelength has been chosen as 455 nm (50-300 mW/cm²) supplied from a modified LED projector. The setup for volumetric printing is as follows: a cuvette with four transparent windows was filled with the resin and was irradiated in one direction with a light sheet of wavelength 1, while an image is projected onto the light sheet from a different angle (90°) with wavelength 2. The image is changed to produce a movie, while the light sheet is moved through the cuvette. The prints result in solidification only in volumes where the light of both wavelengths intersects. The residual uncured resin is removed to obtain the shaped body, which is further washed with ethanol and post-processed. As a first reference object a cube has been chosen with the dimensions 7 mm × 7 mm × 7 mm, where a rectangular hole of 2 mm × 2 mm width connects the center of a first face with the center of the cube and the center of the cube with a second face, wherein the first face and the second face are adjacent faces. In other words, a rectangular tubing or channel connects two adjacent faces via the center of the cube. In a successful print the tubing is free to let a liquid such as the washing solvent run from one face to an adjacent face through the cube. Another reference object may be a spring which connects two plates. In a successful print the spring is functional and can be reversible compressed in a range given by the material properties. Table 4 lists formulations for volumetric printing. The concentration has been adjusted to assure for an absorbance at the first wavelength of 0.2 to 0.5 in the initial state, resulting in comparable uptake of light of the first wavelength. The printing speed has been chosen as 1 mm/min.

**Table 4: Formulations for volumetric printing of complex objects**

| No. | DCPI | ACMO | Co-initiator | UDMA | TMPMP | Additive | 405 nm Intensity |
|---|---|---|---|---|---|---|---|
| 18 | PM-1 12.8 mg | 1 g | MDEA 2 g | 20.4 g | - | - | 15 mW/mm² |
| 19 | PM-3 3.3 mg | 1 g | MDEA 2 g | 20.3 g | - | - | 15 mW/mm² |
| 20 | PM-4 1.6 mg | 1 g | MDEA 2 g | 20.5 g | - | - | 3.7 mW/mm² |
| 21 | PM-5 1.4 mg | 1 g | MDEA 2 g | 20.4 g | - | - | 0.8 mW/mm² |
| 22 | C-1 4.5 mg | 1 g | MDEA 2 g | 20.1g | - | - | 0-20 mW/mm² |
| 23 | PM-5 1.65 mg | - | MDEA 2 g | 19.3 g | 2g | - | 1.1 mW/mm² |
| 24 | PM-5 1.9 mg | 1 g | EHDBA 2 g | 20.3 g | - | DPI 0.2 g | 5 mw/mm² |
| 25 | C-3 8.9 mg | 0.5 g | MDEA 1 g | 10.1 g | - | - | 0-10 mW/mm² |
| 26 | C-3 9.1 mg | - | MDEA 1 g | 10.2 g | 1 g | - | 0-10 mW/mm² |

For comparison with the state of the art formulations 1 and 2 have been tested. The viscosity of both formulations has been measured to 0.062 Pa s using a Kinexus+ Rheometer supplied by Netzsch. With such low viscosity volumetric dual color printing is usually not possible, since any cured voxel floats away from its position. Therefore, no print has been observed for No. 1 and 2. The [2,1-b]naphthopyran derivatives PM-1, PM-3, PM-4, and PM-5 have been successfully tested with the conditions given in table 4, resulting in a free channel through the cube and a reversible compressible spring (No. 18-21). Printing of the same complex objects has also been achieved with formulations No 23 and 24, with the conditions given in table 4 and resulting in a free channel through the cube and a reversible compressible spring. Surprisingly, the comparative experiment with the [1,2-b]naphthopyran C1 or the spiropyran C-3 did not result in a printed object. When No. 8 or 22 is subjected to the printing process no curing is observed, even at the highest intensity the setup could supply. Also a reduction in print speed to 0.5 mm/min which increased the energy uptake did not result in any curing. Both formulations showed absorbance at 405 nm between 0.2 and 0.5. Attempts to print complex objects using formulations No. 25 and 26 did neither result in a cube with a free channel nor in a reversible compressible spring.

It has to be further noted, that the printed objects are colorless, while objects manufactured with dual color photoinitiators according to the state of the art are intensely colored.

Resin R-1 is prepared from PM-6 (1.7 mg), EHDBA (2 g), TMPMP (1 g), Polyethyleneglycole (MW 200,1.5 g), Aerosil 200 (300 mg), and UDMA (22.4 g). The resin R-1 is used for printing in a setup with a light sheet (375 nm), a projector (430 nm - 650 nm) and a moved cuvette as shown in Figs. 5 and 6. The following objects have been printed:
- A cube in the dimensions of 8 mm × 8 mm × 8 mm comprising a channel with a width of 1.5 mm which connects three neighboring faces of the cube via the center.
- A plate of the dimensions of 7 mm × 12 mm and a thickness of 1.5 mm, where cylindrical columns with an aspect ratio of 2:1 (height:width) are printed on one side of the plate. The columns have increasing diameters ranging from 50 µm to 1000 µm.
- A cube in the dimensions of 8 mm × 8 mm × 8 mm with a regular open pore structure and a wall thickness of 1 mm (gyroid structure).A cube in the dimensions of 8 mm × 8 mm × 8 mm with a regular open pore structure and a wall thickness of 2 mm (gyroid structure).
- A model of "The Thinker" by Aguste Rodin in a height of 11.5 mm.
- A cube in the dimensions of 8 mm × 8 mm × 8 mm, wherein each pair of opposing faces is connected by 9 straight cylindrical channels with a diameter of 1.2 mm, forming a regular porous structure.

DCPI: Dual color photoinitiator
DCM: Dichloromethane
TEOA: Triethanolamine
PETA: Pentaerythritol Tetraacrylate
ACMO: Acryloylmorpholine
MDEA: N-Methyldiethanolamine
UDMA: Urethane Dimethacrylate (CAS 72869-86-4)
TMPMP: Trimethylolpropane tris(3-mercaptopropionate)
EHDBA: 2-Ethylhexyl 4-(dimethylamino)benzoate
DPI: Diphenyliodonium hexafluorophosphate
I907: 2-Methyl-4'-(methylthio)-2-morpholinopropiophenon

The features disclosed in the foregoing description and in the dependent claims may, both separately and in any combination thereof, be material for realizing the aspects of the disclosure made in the independent claims, in diverse forms thereof.

## Claims

1. A process for locally polymerizing a starting material by dual color photopolymerization, comprising:
- providing a polymerizable starting material containing photoinitiator molecules which can be converted by sequential optical excitation into a reactive state in which the photoinitiator molecules locally trigger polymerization of the starting material; and
- photopolymerizing the starting material in a local volume by irradiating light of a first wavelength and light of a second wavelength, different from the first wavelength, into the local volume, whereby in the local volume
- the photoinitiator molecules are converted, due to the absorption of the light of the first wavelength, from an initial state in which the photoinitiator molecules substantially do not absorb the light of the second wavelength, into an intermediate state with changed optical properties compared to the initial state, such that the photoinitiator molecules in the intermediate state absorb the light of the second wavelength; and
- the photoinitiator molecules are transferred from the intermediate state to the reactive state due to the absorption of the light of the second wavelength, which triggers the polymerization locally;
wherein
the photoinitiator molecule is represented by one of the following formula (Ib) 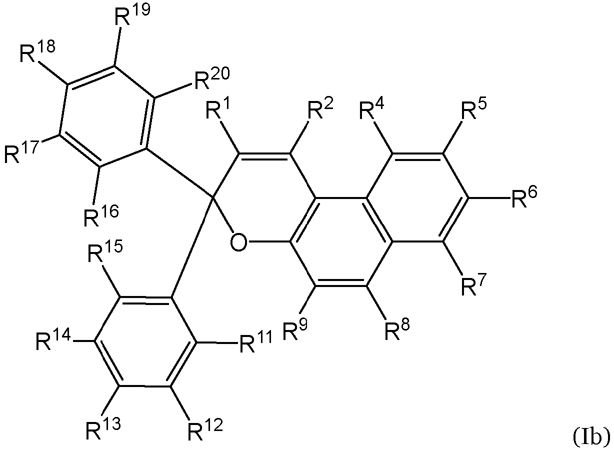
wherein
R¹, R², R⁴ to R⁹, and R¹¹ to R²⁰ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 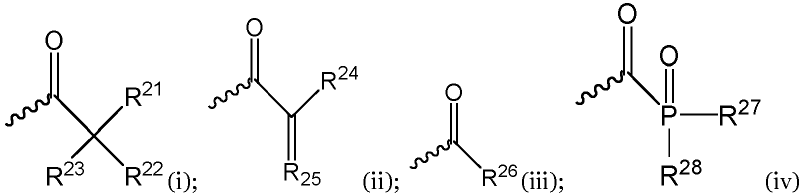 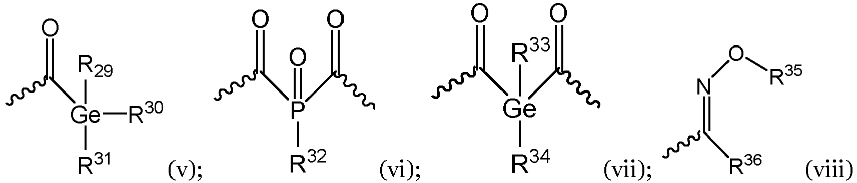
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or
R¹⁵ and R¹⁶ form together a single bond and the remaining R¹, R², R⁴ to R⁹, and R¹¹ to R¹⁴ and R¹⁷to R³⁶ are selected as defined above;
wherein
the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
and
two adjacent groups of R¹, R², R⁴ to R⁹, and R¹¹ to R³⁶may be linked to each other to form a substituted or unsubstituted fused ring structure, preferably, a substituted or unsubstituted fused aromatic C₆-ring, wherein the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

2. The process according to claim 1, wherein
R¹ and R² are H or D; and
at least one of R⁴ to R⁹, and R¹¹ to R²⁰ are independently selected from the group consisting of halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 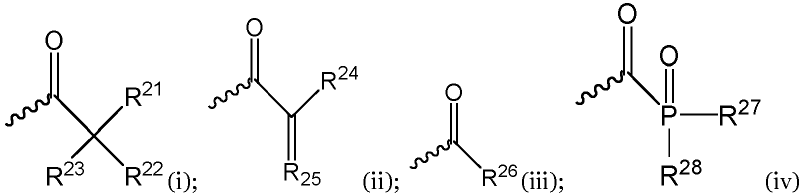 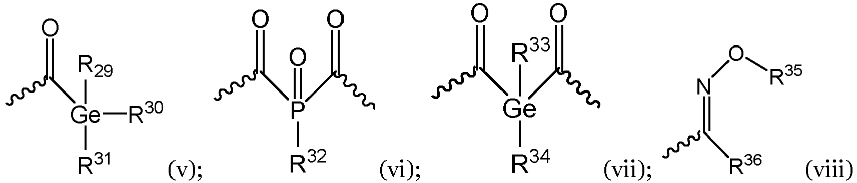
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or
R¹⁵ and R¹⁶ form together a single bond and the remaining R¹, R², R⁴ to R⁹, and R¹¹ to R¹⁴ and R¹⁷ to R³⁶ are selected as defined above;
wherein
the one or more substituents, if present in one or more of R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
and
two adjacent groups of R⁴ to R⁹, and R¹¹ to R³⁶ may be linked to each other to form a substituted or unsubstituted fused ring structure, preferably, a substituted or unsubstituted fused aromatic C₆-ring, wherein the one or more substituents, if present in one or more of R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

3. The process according to claim 1 or 2, wherein
At least one of R⁵, R⁶, R⁸, R¹³, and R¹⁸ is independently selected from the group consisting of halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 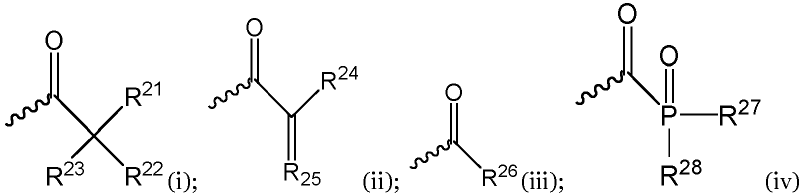 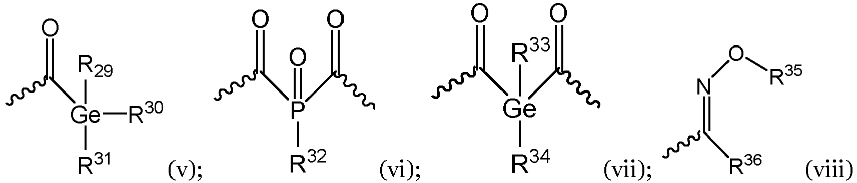
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or
R¹⁵ and R¹⁶ form together a single bond and the remaining R¹, R², R⁴ to R⁹, and R¹¹ to R¹⁴ and R¹⁷to R³⁶ are selected as defined above;
wherein
the one or more substituents, if present in one or more of R⁵, R⁶, R⁸, R¹³, R¹⁸ and R²¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
and
two adjacent groups of R²¹-R³⁶ may be linked to each other to form a substituted or unsubstituted fused ring structure, preferably, a substituted or unsubstituted fused aromatic C₆-ring, wherein the one or more substituents, if present in one or more of R²¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

4. The process according to any of the preceding claims, wherein R¹, R², R⁴ to R⁹, and R¹¹ to R²⁰ are independently selected from the group consisting of H; D; substituted or unsubstituted C₆-C₄₈-aryl; substituted or unsubstituted C₂-C₄₂-heteroaryl;
substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, wherein R' is independently selected from the group consisting of substituted or unsubstituted C₁-C₂₀-alkyl, substituted or unsubstituted C₁-C₂₀-hetero alkyl, , two R' may form a ring structure; and the following structures (i) or (iii) 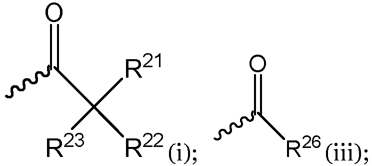
wherein R²¹ to R²³ and R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or
R¹⁵ and R¹⁶ form together a single bond and the remaining R¹, R², R⁴ to R⁹, and R¹¹ to R¹⁴ and R¹⁷to R³⁶ are selected as defined above;
wherein
the one or more substituents, if present in one or more of R¹, R², R⁴ to R⁹, and R¹¹ to R²³ and R²⁶, are independently selected from the group consisting of D; halogen; substituted or unsubstituted C₂-C₄₉-aryl acyl; and substituted or unsubstituted C₂-C₄₉-aryl ester;
and
two adjacent groups of R¹, R², R⁴ to R⁹, and R¹¹ to R²³ and R²⁶ may be linked to each other to form a substituted or unsubstituted fused ring structure, preferably, a substituted or unsubstituted fused aromatic C₆-ring, wherein the one or more substituents, if present in one or more of R¹ to R²³, are independently selected from the group consisting of D; halogen; substituted or unsubstituted C₂-C₄₉-aryl acyl; and substituted or unsubstituted C₂-C₄₉-aryl ester.

5. The process according to any of the preceding claims, wherein R⁸ and R⁹ are linked to each other to form a substituted or unsubstituted fused ring structure.

6. The process according to any of the preceding claims, wherein R⁶ and R⁷ are linked to each other to form a substituted or unsubstituted fused ring structure.

7. The process according to any of the preceding claims, wherein at least one of R¹, R², R⁴ to R⁹, and R¹¹ to R²⁰ is selected from the following structures (i) to (viii) 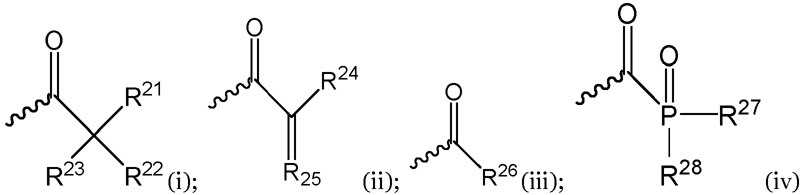 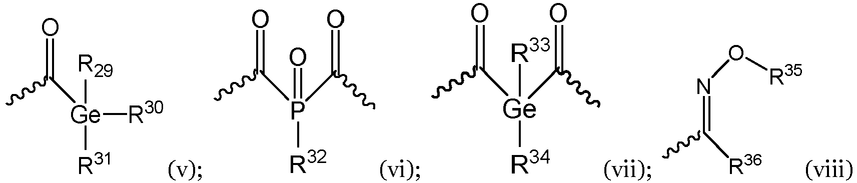
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or
R¹⁵ and R¹⁶ form together a single bond and the remaining R¹, R², R⁴ to R⁹, and R¹¹ to R¹⁴ and R¹⁷to R³⁶ are selected as defined above;
wherein
the one or more substituents, if present in one or more of R²¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
and
two adjacent groups of R²¹-R³⁶ may be linked to each other to form a substituted or unsubstituted fused ring structure, preferably, a substituted or unsubstituted fused aromatic C₆-ring, wherein the one or more substituents, if present in one or more of R²¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

8. The process according to any of the preceding claims, wherein at least one of R¹, R², R⁴ to R⁹, and R¹¹ to R²⁰ is selected from the following structures (i) and (iii) 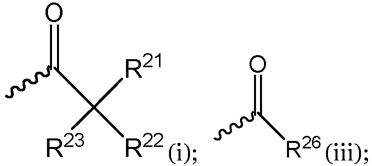
wherein R²¹ to R²³ and R²⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or
R¹⁵ and R¹⁶ form together a single bond and the remaining R¹, R², R⁴ to R⁹, and R¹¹ to R¹⁴ and R¹⁷to R³⁶ are selected as defined above; wherein
the one or more substituents, if present in one or more of R²¹ to R²³ and R²⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
and
two adjacent groups of R²¹ to R²³ and R²⁶ may be linked to each other to form a substituted or unsubstituted fused ring structure, preferably, a substituted or unsubstituted fused aromatic C₆-ring, wherein the one or more substituents, if present in one or more of R²¹ to R²³ and R²⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

9. The process according to claim 8, wherein at least one of, more preferably one of, R⁵, R⁶ and R⁸ is selected from the following structures (i) and (iii) 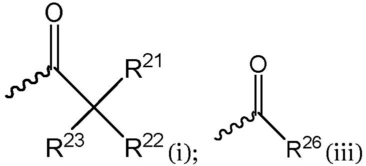
wherein R²¹ to R²³ and R²⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
wherein
the one or more substituents, if present in one or more of R²¹ to R²³ and R²⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
and
two adjacent groups of R²¹ to R²³ and R²⁶ may be linked to each other to form a substituted or unsubstituted fused ring structure, preferably, a substituted or unsubstituted fused aromatic C₆-ring, wherein the one or more substituents, if present in one or more of R²¹ to R²³ and R²⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

10. The process according to any of the preceding claims, wherein at least one of R¹ to R²⁰ is independently selected from the group consisting of 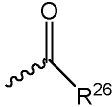 (iii) or an electron withdrawing group.

11. The process according to any of the preceding claims, wherein at least one of, preferably one of R⁵, R⁶ and R⁸ is

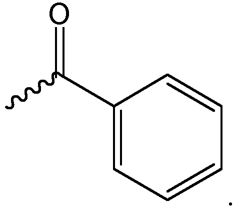

12. The process according to claim 1, wherein R¹ to R²⁰ are each H.

13. The process according to any of the preceding claims, wherein the photoinitiator molecule has the formula PM-1 to PM-6

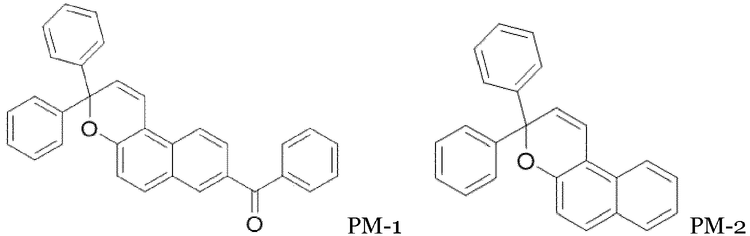

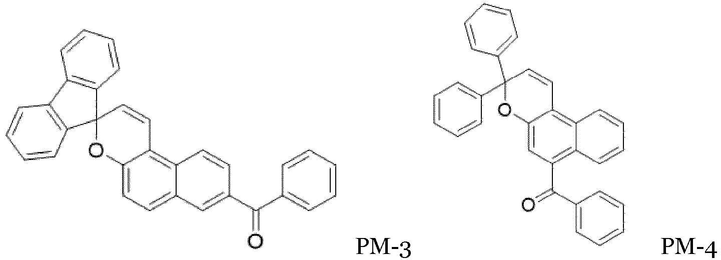

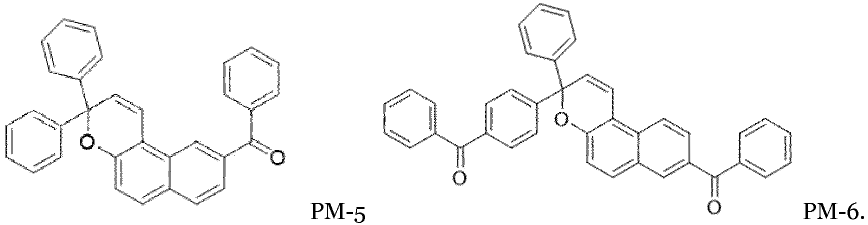

14. Use of a photoinitiator molecule in a process for locally polymerizing a starting material by dual color photopolymerization;
wherein
the photoinitiator molecule is represented by one of the following formula (Ib) 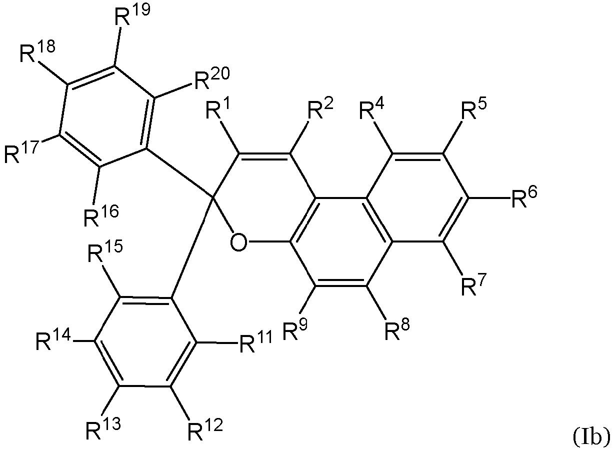
wherein
R¹, R², R⁴ to R⁹, and R¹¹ R²⁰ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 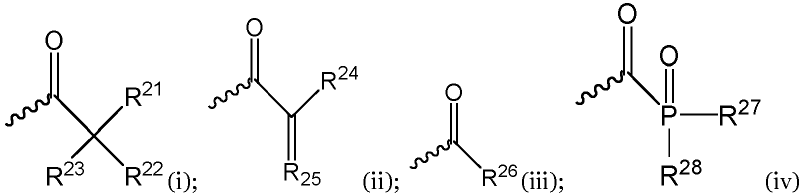 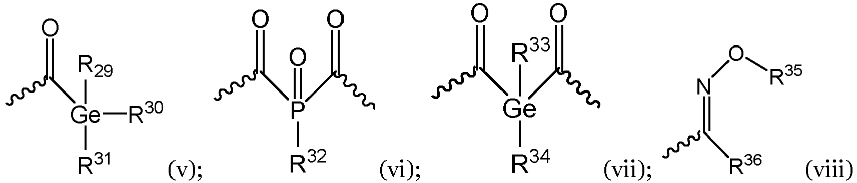
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester;
substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or
R¹⁵ and R¹⁶ form together a single bond and the remaining R¹, R², R⁴ to R⁹, and R¹¹ to R¹⁴ and R¹⁷to R³⁶ are selected as defined above;
wherein
the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
and
two adjacent groups of R¹, R², R⁴ to R⁹, and R¹¹ to R³⁶ may be linked to each other to form a substituted or unsubstituted fused ring structure, preferably, a substituted or unsubstituted fused aromatic C₆-ring, wherein the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.

15. Apparatus for locally polymerizing a starting material by dual color photopolymerization, comprising:
- an intake for a polymerizable starting material;
- light generating means arranged to generate light of a first wavelength and light of a second wavelength, the second wavelength being different from the first wavelength; and
- a light guide device arranged to irradiate the light of the first wavelength and the light of the second wavelength into a local volume;
said device being adapted to perform the following procedure:
- taking up the polymerizable starting material by said intake, said starting material containing photoinitiator molecules which can be excited by sequential optical excitation into a reactive state in which the photoinitiator molecules locally initiate polymerization of the starting material; and
- photopolymerizing the starting material in a local volume by irradiating the light of the first wavelength and the light of the second wavelength into the local volume, whereby in the local volume
- the photoinitiator molecules, due to the absorption of the light of the first wavelength, are converted from an initial state in which the photoinitiator molecules substantially do not absorb the light of the second wavelength into an intermediate state with changed optical properties compared to the initial state, such that the photoinitiator molecules in the intermediate state absorb the light of the second wavelength; and
- the photoinitiator molecules are transferred from the intermediate state to the reactive state due to the absorption of the light of the second wavelength, which triggers the polymerization locally,
wherein
the photoinitiator molecule is represented by one of the following formula (Ib) 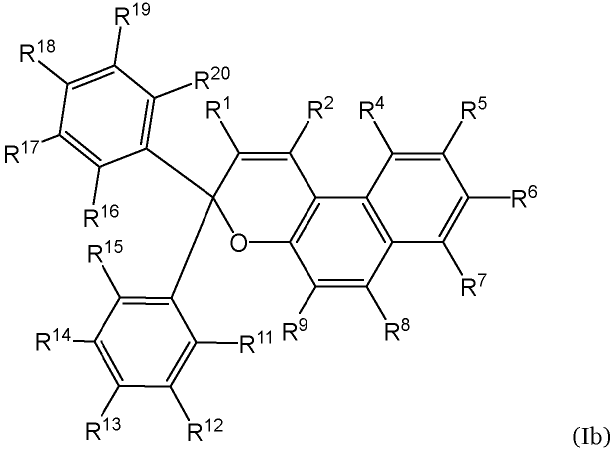
wherein
R¹, R², R⁴ to R⁹, and R¹¹ R²⁰ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl, substituted or unsubstituted C₁-C₂₀-hetero alkyl, and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl, substituted or unsubstituted C₂-C₂₀-alkenyl; and the following structures (i) to (viii) 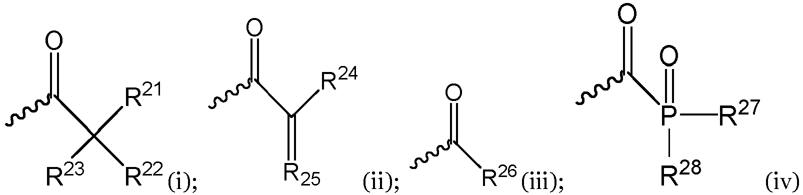 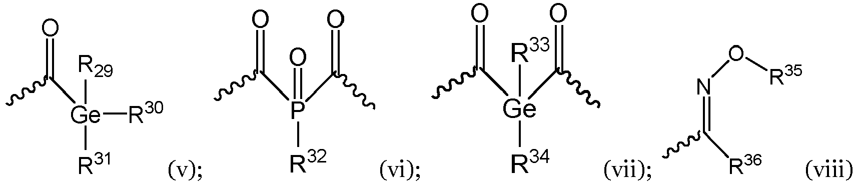
wherein R²¹ to R³⁶ are independently selected from the group consisting of H; D; halogen; NO₂; CN; OH; SH; substituted or unsubstituted C₁-C₂₀-alkyl; substituted or unsubstituted C₃-C₂₀-cycloalkyl; substituted or unsubstituted C₆-C₄₈-aryl; substituted or unsubstituted C₂-C₄₂-heteroaryl; substituted or unsubstituted C₂-C₄₉-alkyl acyl; substituted or unsubstituted C₂-C₄₉-aryl acyl; substituted or unsubstituted C₁-C₂₀-alkoxy; substituted or unsubstituted C₆-C₄₈-aryloxy, and NH₂; substituted or unsubstituted C₁-C₂₀-alkyl ester; substituted or unsubstituted C₆-C₄₈-aryl ester; substituted or unsubstituted C₁-C₂₀ alkyl amide; substituted or unsubstituted C₆-C₄₈-aryl amide; NR'₂, SiR'₃, -O-SiR'₃ wherein R' is independently selected from the group consisting of substituted or unsubstituted C₁-C₂₀-alkyl and substituted or unsubstituted C₆-C₄₈-aryl, two R' may form a ring structure; substituted or unsubstituted carboxylic acids and salts thereof; substituted or unsubstituted sulfonic acids and salts thereof; substituted or unsubstituted sulfonic esters; substituted or unsubstituted sulfonic amides; formyl; ether, thioether; carbonate; carbonate ester; sulfates; boronic acids; boronic esters; phosphonic acids; phosphonic esters; phosphines; phosphates; peroxycarbonic acids; thiocarbonic acids; sulfinic acids; sulfinic esters; sulfonates; thiolesters, sulfoxides; sulfones; hydrazides; thioaldehydes; ketones; thioketones; oximes; hydrazines; nitroso; azo; diazo; diazonium; isocyanides; cyanate; isocyanate; thiocyanate; isothiocyanate; hydroperoxide; peroxide; acetals; ketal; orthoester; orthocarbonate esters; ammonium; imines; imides; azide; nitrate; isonitrile; nitrosoxy; substituted or unsubstituted carbamates; substituted or unsubstituted ethers; substituted or unsubstituted polyether carbamates; substituted or unsubstituted arylazo; substituted or unsubstituted C₂-C₂₀-alkynyl and substituted or unsubstituted C₂-C₂₀-alkenyl;
or
R¹⁵ and R¹⁶ form together a single bond and the remaining R¹, R², R⁴ to R⁹, and R¹¹ to R¹⁴ and R¹⁷to R³⁶ are selected as defined above;
wherein
the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH;
and
two adjacent groups of R¹, R², R⁴ to R⁹, and R¹¹ to R³⁶ may be linked to each other to form a substituted or unsubstituted fused ring structure, preferably, a substituted or unsubstituted fused aromatic C₆-ring, wherein the one or more substituents, if present in one or more of R¹, R², R⁴ to R⁹, and R¹¹ to R³⁶, are independently selected from the group consisting of D; halogen; NO₂; CN, C₂-C₄₉-alkyl acyl; substituted or unsubstituted C₁-C₂₀-alkoxy; substituted or unsubstituted C₆-C₄₈-aryloxy; substituted or unsubstituted C₂-C₄₉-aryl acyl; substituted or unsubstituted C₂-C₄₉-aryl ester, (meth)acrylate; tosyl; NH₂; and OH.
